(19) Europäisches Patentamt
European Patent Office
Office européen des brevets

(11) EP 2 500 398 B1

(12) **EUROPÄISCHE PATENTSCHRIFT**

(45) Veröffentlichungstag und Bekanntmachung des Hinweises auf die Patenterteilung:
**20.08.2014 Patentblatt 2014/34**

(21) Anmeldenummer: **12171044.6**

(22) Anmeldetag: **20.05.2008**

(51) Int Cl.:
***C09K 11/06*** *(2006.01)* ***C07F 15/00*** *(2006.01)*
***H01L 51/00*** *(2006.01)* ***C09B 55/00*** *(2006.01)*
***C09B 57/00*** *(2006.01)* ***C09B 57/10*** *(2006.01)*
*H01L 51/50* *(2006.01)*

(54) **Phosphoreszente Metallkomplexverbindung, strahlungsemittierendes Bauelement aufweisend eine phosphoreszente Metallkomplexverbindung und Verfahren zur Herstellung einer phosphoreszenten Metallkomplexverbindung**

Phosphorescent metal complex compound, radiation-emitting module comprising a phosphorescent metal complex compound and method for producing a phosphorescent metal complex compound

Connexion à complexe métallique phosphorescente, composant émettant un rayonnement présentant une connexion à complexe métallique phosphorescente et procédé de fabrication d'une connexion à complexe métallique phosphorescente

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität:
**21.05.2007 DE 102007023554**
**22.05.2007 DE 102007023749**
**15.01.2008 DE 102008004471**
**25.01.2008 DE 102008006113**
**29.01.2008 DE 102008006573**
**27.03.2008 DE 102008015940**

(43) Veröffentlichungstag der Anmeldung:
**19.09.2012 Patentblatt 2012/38**

(62) Dokumentnummer(n) der früheren Anmeldung(en) nach Art. 76 EPÜ:
**08758108.8 / 2 167 608**

(73) Patentinhaber: **OSRAM Opto Semiconductors GmbH**
**93055 Regensburg (DE)**

(72) Erfinder:
- **Adler, Jürgen**
  **91096 Kleinseebach (DE)**
- **Kanitz, Andreas, Dr.**
  **91315 Höchstadt (DE)**
- **Schmid, Günter, Dr.**
  **91334 Hemhofen (DE)**
- **Freydenzon, Oksana**
  **90429 Nürnberg (DE)**
- **Maltenberger, Anna**
  **91359 Leutenbach (DE)**

(74) Vertreter: **Epping - Hermann - Fischer Patentanwaltsgesellschaft mbH**
**Schloßschmidstraße 5**
**80639 München (DE)**

(56) Entgegenhaltungen:
**JP-A- 2007 084 635 US-A1- 2006 154 106**

- **REN ET AL: "A new class of o-hydroxyaryl-substituted N-heterocyclic carbene ligands and their complexes with palladium", JOURNAL OF ORGANOMETALLIC CHEMISTRY, ELSEVIER-SEQUOIA S.A. LAUSANNE, CH, Bd. 692, Nr. 10, 29. März 2007 (2007-03-29), Seiten 2092-2098, XP022008542, ISSN: 0022-328X, DOI: 10.1016/J.JORGANCHEM.2007.01.028**
- **COLEMAN K S ET AL: "Silver(I) complex of a new imino-N-heterocyclic carbene and ligand transfer to palladium(II) and rhodium(I)", JOURNAL OF THE CHEMICAL SOCIETY, DALTON TRANSACTIONS, CHEMICAL SOCIETY. LETCHWORTH, GB, 18. Juni 2003 (2003-06-18), Seiten 2917-2922, XP002309661, ISSN: 1472-7773**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- MOSER MICHAEL ET AL: "1,8-Bis(imidazolin-2-yliden-1-yl)carbazol ide (bimca): A New CNC Pincer-Type Ligand with Strong Electron-Donating Properties. Facile Oxidative Addition of Methyl Iodide to Rh(bimca)(CO)", ORGANOMETALLICS, ACS, WASHINGTON, DC, US, Bd. 26, Nr. 4, 13. Januar 2007 (2007-01-13), Seiten 1024-1030, XP002511107, ISSN: 0276-7333, DOI: 10.1021/OM060952Z [gefunden am 2007-01-13]
- BOYDSTON ANDREW J ET AL: "Synthesis and Study of Bidentate Benzimidazolylidene-Group 10 Metal Complexes and Related Main-Chain Organometallic Polymers", ORGANOMETALLICS, ACS, WASHINGTON, DC, US, Bd. 25, Nr. 26, 1. Januar 2006 (2006-01-01), Seiten 6087-6098, XP002511108, ISSN: 0276-7333, DOI: 10.1021/OM060494U [gefunden am 2006-11-22]
- KETZ B E ET AL: "STRUCTURE AND REACTIVITY OF AN ALLYLPALLADIUM N-HETEROCYCLIC CARBENE ENOLATE COMPLEX", ORGANOMETALLICS, ACS, WASHINGTON, DC, US, Bd. 23, Nr. 12, 1. Januar 2004 (2004-01-01), Seiten 2835-2837, XP008049060, ISSN: 0276-7333, DOI: 10.1021/OM049838B

## Beschreibung

Die Erfindung betrifft eine phosphoreszente Metallkomplexverbindung, ein strahlungsemittierendes Bauelement, das die phosphoreszente Metallkomplexverbindung aufweist, und ein Verfahren zur Herstellung der phosphoreszenten Metallkomplexverbindung.

Diese Patentanmeldung beansprucht die Priorität der deutschen Patentanmeldungen 10 2008 015 940.9, 10 2008 004 471.7, 10 2008 006 113.1, 10 2008 006 573.0 und 10 2007 023 554.4 und 10 2007 023 749.0, deren Offenbarungsgehalt hiermit durch Rückbezug aufgenommen wird.

Für strahlungsemittierende Bauelemente wie beispielsweise organische Licht emittierende Dioden (OLEDs) werden organische Materialien eingesetzt, die farbiges Licht emittieren. Bisher gibt es eine Vielzahl an Materialien, die rotes oder grünes Licht emittieren. Mit bisherigen Methoden konnten bisher jedoch noch keine stabilen, tiefblaues, hellblaues oder blau-grünes Licht emittierende Materialien hergestellt werden.

In JP 2007/084635 A werden Metallkomplexe mit drei- oder mehrzähnigen Carbenliganden beschrieben.

Aufgabe der Erfindung ist es, eine neue phosphoreszente Verbindung bereitzustellen, die farbiges, beispielsweise tiefblaues, hellblaues, blau-grünes oder grünes Licht emittieren kann und stabil ist. Eine weitere Aufgabe besteht darin, ein strahlungsemittierendes Bauelement bereitzustellen, das eine solche phosphoreszente Verbindung aufweist. Die Herstellung einer phosphoreszenten Verbindung ist eine weitere Aufgabe der Erfindung.

Diese Aufgaben werden durch die Gegenstände der Ansprüche 1, 8 und 9 gelöst. Weitere Ausführungsformen sind Gegenstand von weiteren, abhängigen Ansprüchen.

Es wird eine phosphoreszente Metallkomplexverbindung bereitgestellt, die zumindest ein metallisches Zentralatom M und zumindest einen durch das metallische Zentralatom M koordinierten Liganden umfasst, wobei das eine metallische Zentralatom M und der Ligand einen sechsgliedrigen metallazyklischen Ring bilden. Damit wird eine stabile Komplexverbindung bereitgestellt, die farbiges Licht, beispielsweise im tiefblauen, hellblauen, blau-grünen oder grünen Bereich, emittieren kann.

Der metallazyklische Ring kann zumindest zwei Heteroatome umfassen. Weiterhin ist das Zentralatom des metallazyklischen Rings an mindestens ein Atom des Liganden koordiniert oder gebunden, das ein freies Elektronenpaar aufweist, beispielsweise an ein N-Atom oder an das C-Atom eines Carbens.

Weiterhin kann der mit dem metallischen Zentralatom M einen sechsgliedrigen metallazyklischen Ring bildende Ligand im unkoordinierten Zustand eine tautomerisierbare Einheit aufweisen. Die tautomerisierbare Einheit kann sich über ein oder mehrere, beispielsweise zwei, Ringsysteme, die der Ligand umfasst, erstrecken. Im koordinierten Zustand kann der Ligand Mesomerie aufweisen, was eine Delokalisierung der Elektronen in dem sechsgliedrigen metallazyklischen Ring bewirkt.

Formeln 1 und 2 zeigen Beispiele für tautomerisierbare Liganden. Durch Ladungsumverteilung ändert sich die alternierende Ladungsverteilung, während ein Substituent (H) der Methylengruppe (Formel 1) oder der NH-Gruppe (Formel 2)

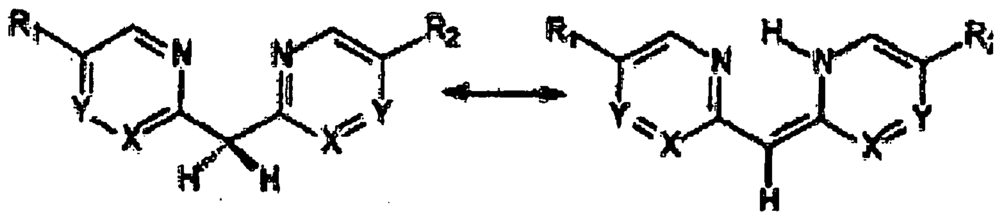

zu einem N-Atom eines aromatischen Ringes wechselt.

(a) (b)

Formel 1

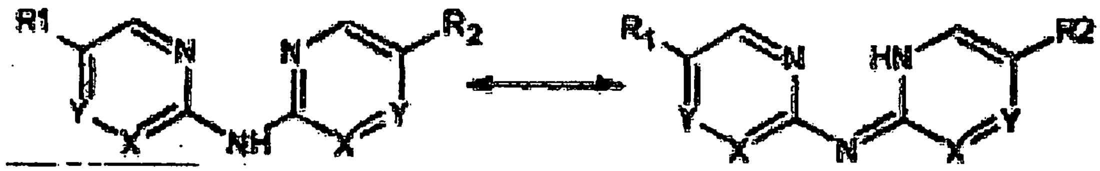

(a) (b)

Formel 2

Für X und Y können hier beispielsweise C-H oder N eingesetzt werden, $R_1$ und $R_2$ können in diesem Beispiel frei gewählt werden.

Die in den Formeln 1 und 2 gezeigten Strukturformeln stellen jeweils nur Beispiele zur Veranschaulichung der Tautomerisierbarkeit von Liganden dar.

Die tautomerisierbaren Einheiten in den Liganden ermöglichen die Koordination an ein metallisches Zentralatom M unter Bildung eines sechsgliedrigen metallazyklischen Ringes, wobei ein Proton des Liganden abgespalten wird.

Das metallische Zentralatom M kann dabei aus einer Gruppe ausgewählt sein, die Ir, Pt, Au, Re, Rh, Ru, Os, Pd, Ag, Zn, Al und Lanthanoide, beispielsweise Eu, umfasst. Die Gruppe kann weiterhin Metalle oder Übergangsmetalle mit einer Ordnungszahl > 35 umfassen.

In einer nicht erfindungsgemäßen Ausführungsform weist die phosphoreszente Metallkomplexverbindung die Strukturformel, wie sie in Formel 3 gezeigt ist,

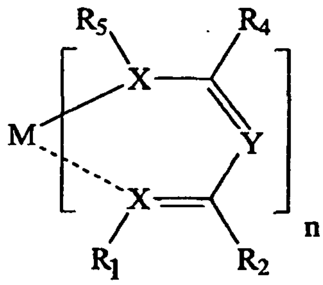

Formel 3

auf, wobei gilt:

n = 1 bis 3,
Y = C-H, N, P, As, Sb, C-$R_y$, Si-$R_y$, Ge-$R_y$,
X = N, O, P, As, Sb,
$R_1$, $R_2$, $R_y$, $R_4$ und $R_5$ sind - unabhängig voneinander - H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN,
$R_1$ und $R_5$ umfassen ein freies Elektronenpaar, wenn X = O.

Für den Fall, dass X = O, ist die Doppelbindung X=C in Formel 3 als Teil eines delokalisierten Elektronensystems zu verstehen, und die Reste $R_1$ und $R_2$ sind so ausgebildet, dass das O an einem $6\pi$-Elektronensystem teilnimmt. Dies gilt für die folgenden Formeln für X = O analog.

Beispielsweise ist n = 1 oder 2, wenn M = Pt, n = 1, wenn M = Au und n = 1, 2 oder 3, wenn M = Ir (gilt auch für die im Folgenden gezeigten Verbindungen). Die Anzahl der Liganden, mit denen das Zentralatom einen sechsgliedrigen metallazyklischen Ring bildet ist davon abhängig, wie viele weitere Liganden an das Zentralatom koordiniert sind. Ist M = Au, können weiterhin Au-Au Wechselwirkungen auftreten, die beispielsweise zu Brückenbildungen zwischen Metallkomplexverbindungen führen.

Die Formel 3 sowie die folgenden, eine Metallkomplexverbindung zeigende Formeln zeigen nur den oder die Liganden, die mit dem Zentralatom einen sechsgliedrigen metallazyklischen Ring bilden. Die vollständige Formel 3 und die folgenden Formeln sind $L_mM[]_n$ mit n = 1 bis 3, m = 3-n, [] = Liganden, die mit dem Zentralatom einen sechsgliedrigen metallazyklischen Ring bilden und L = ein Ligand, der mit dem Zentralatom einen fünfgliedrigen Ring bildet oder zwei Liganden, die einzähnig an das Zentralatom koordinieren. Die Anzahl aller Liganden kann beispielsweise so hoch sein, dass das Zentralatom eine Koordinationssphäre aufweist, in der für das Zentralatom die 18-Elektronen-Regel erfüllt ist.

Unter allen Liganden der Formel 3, die mit dem Zentralatom einen sechsgliedrigen metallazyklischen Ring bilden, ist mindestens ein Ligand vorhanden, der kein Acetylacetonat ist, das heißt, bei dem nicht gleichzeitig gilt: X = O für beide X, $R_2$ und $R_4$ = $CH_3$, $R_1$ und $R_5$ sind jeweils ein freies Elektronenpaar und Y = CH.

"Substituiert" wird hier und im Folgenden so verstanden, dass die jeweiligen Gruppen einen oder mehrere Substituenten aufweisen, wobei die Substituenten frei gewählt werden können und beispielsweise aus einer Gruppe ausgewählt sind, die H, Halogene und Alkylreste umfasst.

Alkylreste können hier und im Folgenden beispielsweise ein bis 20 C-Atome umfassen.

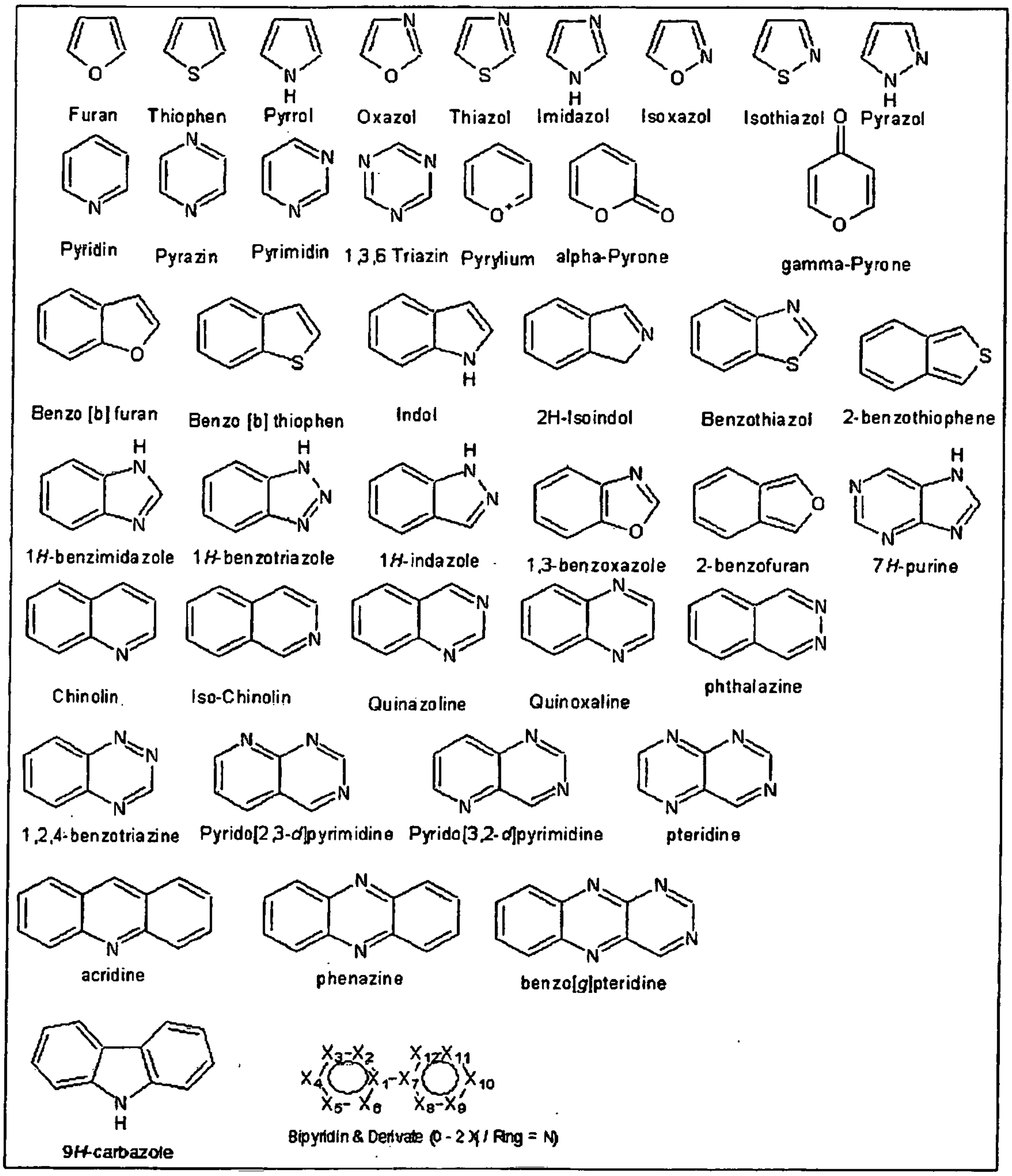

Furan Thiophen Pyrrol Oxazol Thiazol Imidazol Isoxazol Isothiazol Pyrazol

Pyridin Pyrazin Pyrimidin 1,3,6 Triazin Pyrylium alpha-Pyrone gamma-Pyrone

Benzo [b] furan Benzo [b] thiophen Indol 2H-Isoindol Benzothiazol 2-benzothiophene

1*H*-benzimidazole 1*H*-benzotriazole 1*H*-indazole 1,3-benzoxazole 2-benzofuran 7*H*-purine

Chinolin Iso-Chinolin Quinazoline Quinoxaline phthalazine

1,2,4-benzotriazine Pyrido[2,3-*d*]pyrimidine Pyrido[3,2-*d*]pyrimidine pteridine

acridine phenazine benzo[*g*]pteridine

9*H*-carbazole

Bipyridin & Derivate (0 - 2 X / Ring = N)

Formel 4

Eine Auswahl an Beispielen für Heterocyclen, die für $R_1$, $R_2$, $R_y$, $R_4$ und $R_5$ eingesetzt werden können, sind in Formel 4 angegeben, wobei jeweils Grundstrukturen gezeigt sind, die wiederum Substituenten aufweisen können. Die Bindung dieser beispielhaften $R_1$, $R_2$, $R_y$, $R_4$ und $R_5$ an den Liganden kann jeweils an einer beliebigen, bindungsfähigen Stelle des Grundkörpers erfolgen.

In Formel 5 ist eine beispielhafte Strukturformel für Y = C-Ry (a) bzw. Y = Si-$R_y$ (b) gezeigt:

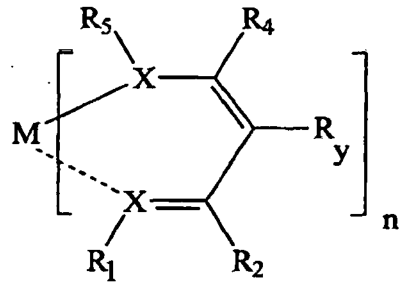

(a)

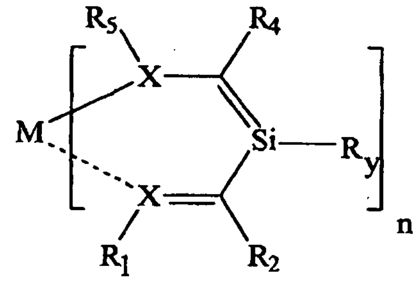

(b)

Formel 5

Weiterhin können die in den Formeln 3 und 5 gezeigten Reste $R_1$ und/oder $R_5$ zusätzlich an das metallische Zentralatom M koordiniert sein. Damit wird die Verbindung noch weiter stabilisiert. Der oder die Liganden an dem Zentralatom M können eine Akzeptorwirkung aufweisen und somit zu kürzeren Wellenlängen des emittierten Lichts der Verbindung führen. Eine Emission von farbigem, beispielsweise tiefblauem, hellblauem, blau-grünem oder grünem Licht wird somit ermöglicht.

In einer weiteren nicht erfindungsgemäßen Ausführungsform können zumindest eines aus $R_1$ und $R_2$, $R_2$ und $R_y$, $R_y$ und $R_4$, $R_4$ und $R_5$ miteinander verbrückt sein. Die Verbrückungen können unabhängig voneinander auftreten. In Formel 6 sind schemenhaft Verbrückungen B1, B2, B3 und B4 an dem Liganden gezeigt.

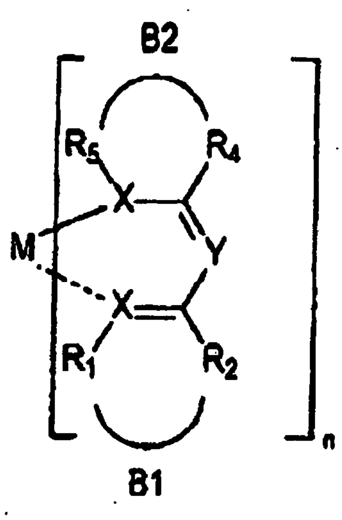

(a)

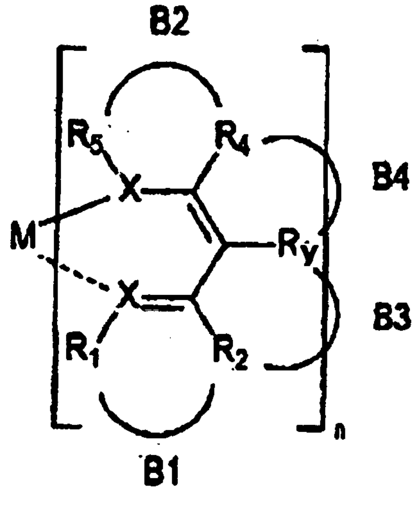

(b)

Formel 6

Die nicht erfindungsgemäße Verbindung kann aus einer Strukturformel gemäß Formel 7 ausgewählt sein, wobei gilt:

n = 1 bis 3,
Y = C-H, N, P, As, Sb, C-$R_y$, Si-$R_y$, Ge-$R_y$,
= N, O, P, As, Sb,
$X_1$, $X_2$, $X_3$, $X_4$, $X_5$, $X_6$, $X_7$ und $X_8$ sind - unabhängig voneinander - C oder - wenn $R_{11}$, $R_{12}$, $R_3$, $R_{14}$, $R_{15}$, $R_6$, $R_7$ oder $R_8$ ein freies Elektronenpaar umfassen - N,
$R_y$, $R_{11}$, $R_{12}$, $R_3$, $R_{14}$, $R_{15}$, $R_6$, $R_7$ und $R_8$ sind - unabhängig voneinander - H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide,

Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN.

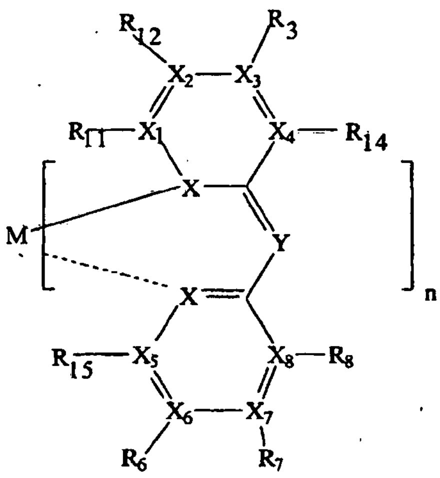

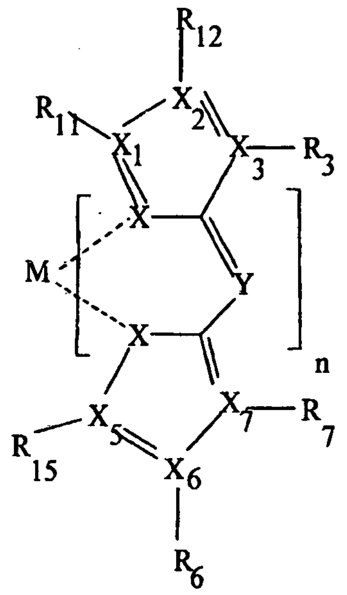

(a) (b)

Formel 7

Durch die Verbrückungen kann zusätzliche Stabilität der Metallkomplexverbindung sowie eine Verschiebung der Wellenlänge des emittierten Lichts z. B. in den kurzwelligen Bereich erreicht werden.

Die Verbindung gemäß Formel 7 kann weiterhin symmetrisch ausgeformt sein und $X_1 = X_5$, $R_{11} = R_{15}$, $X_2 = X_6$, $R_{12} = R_6$, $X_3 = X_7$, $R_3 = R_7$, $X_4 = X_8$ und $R_{14} = R_8$ gesetzt werden.

Verbindungen gemäß der Strukturformel in Formel 7a können beispielsweise aus Bispyridinderivaten abgeleitet werden. Dann kann zum Beispiel X = N und $X_1 = X_2 = X_3 = X_4 = X_5 = X_6 = X_7 = X_8$ = C gesetzt werden. Die Reste $R_{11}$, $R_{12}$, $R_3$, $R_{14}$, $R_{15}$, $R_6$, $R_7$ und $R_8$ können frei unter den oben genannten Möglichkeiten gewählt werden. Für $R_6$ und $R_{12}$ können dann beispielsweise elektronenziehende Substituenten eingesetzt werden, die ausgewählt sind aus einer Gruppe, die CN, F, 4-Pyridyl, Triazyl, 2-Pyrimidyl, 5-Pyrimidyl, 2-Oxazol, 4-Oxazol, 2-Thiazolyl, 4-Thiazol, Trifluormethyl und Hexafluorisopropyliden umfasst.

Ein weiteres Beispiel für eine Verbindung gemäß der Strukturformel in Formel 7a ist abgeleitet aus Bispyrazinderivaten, und ergibt sich aus X = N, $X_1 = X_2 = X_4 = X_5 = X_6 = X_8$ = C und $X_3 = X_7$ = N. $R_3$ und $R_7$ sind ein freies Elektronenpaar.

Verbindungen, die sich aus Bispyrimidinderivaten ableiten, ergeben sich aus X = N, $X_1 = X_2 = X_3 = X_5 = X_6 = X_7$ = C und $X_4 = X_a$ = N, wobei $R_4$ und $R_8$ ein freies Elektronenpaar sind. Für $R_6$ und $R_{12}$ können dann beispielsweise elektronenziehende Substituenten eingesetzt werden, die ausgewählt sind aus einer Gruppe, die CN, F, 4-Pyridyl, Triazyl, 2-Pyrimidyl, 5-Pyrimidyl, 2-Oxazol, 4-Oxazol, 2-Thiazolyl, 4-Thiazol, Trifluormethyl und Hexafluorisopropyliden umfasst.

Verbindungen gemäß Formel 7a können sich auch aus Bistriazinderivaten ergeben. Dann wird X = N, $X_2 = X_3 = X_5 = X_7$ = C, $X_1 = X_4 = X_6 = X_8$ = N, wobei $R_1$, $R_4$, $R_6$ und $R_8$ jeweils ein freies Elektronenpaar sind. Für $R_3$ und $R_7$ können dann beispielsweise elektronenziehende Substituenten eingesetzt werden, die ausgewählt sind aus einer Gruppe, die CN, F, 4-Pyridyl, Triazyl, 2-Pyrimidyl, 5-Pyrimidyl, 2-Oxazol, 4-Oxazol, 2-Thiazolyl, 4-Thiazol, Trifluormethyl und Hexafluorisopropyliden umfasst. Alternativ können die Stickstoffpositionen permutieren, so dass X = N, $X_1 = X_3 = X_5 = X_7$ = C, $X_2 = X_4 = X_6 = X_8$ = N, wobei $R_2$, $R_4$, $R_6$ und $R_8$ jeweils ein freies Elektronenpaar sind oder X = N, $X_1 = X_2 = X_5 = X_6$ = C, $X_3 = X_4 = X_7 = X_8$ = N, wobei $R_3$, $R_4$, $R_7$ und $R_8$ jeweils ein freies Elektronenpaar sind.

Eine Verbindung gemäß der Strukturformel in Formel 7b kann beispielsweise aus Bispyrrolderivaten abgeleitet werden, indem X = N, $X_1 = X_2 = X_3 = X_5 = X_6 = X_7$ = C gesetzt werden. Für $R_{11}$ und $R_{15}$ können dann beispielsweise elektronenziehende Substituenten eingesetzt werden, die ausgewählt sind aus einer Gruppe, die CN, F, 4-Pyridyl, Triazyl, 2-Pyrimidyl, 5-Pyrimidyl, 2-Oxazol, 4-Oxazol, 2-Thiazolyl, 4-Thiazol, Trifluormethyl und Hexafluorisopropyliden

umfasst.

Die Reste $R_{11}$ und $R_{12}$, $R_{12}$ und $R_3$, $R_3$ und $R_{14}$, $R_{14}$ und $R_y$, $R_y$ und $R_8$, $R_{15}$ und $R_6$, $R_6$ und $R_7$ oder $R_7$ und $R_8$ können weiterhin - unabhängig voneinander - weitere Verbrückungen bilden. Damit können kondensierte Systeme im Liganden bereitgestellt werden.

Beispielsweise können solche kondensierten Systeme eine nicht erfindungsgemäße Strukturformel gemäß den Formeln 8a, 8b und 8c aufweisen, wobei jede der Positionen $X_1$ bis $X_{12}$ unabhängig voneinander N oder C-R sein kann und R ausgewählt ist aus H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN. R kann für jedes X unterschiedlich sein.

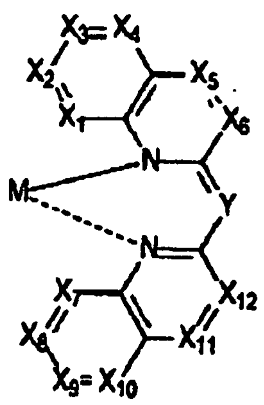

(a)

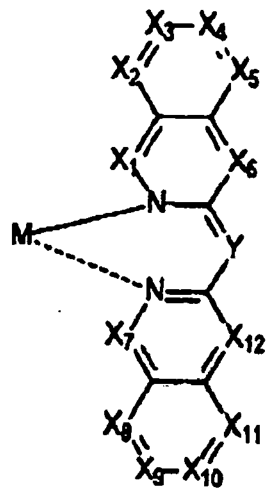

(b)

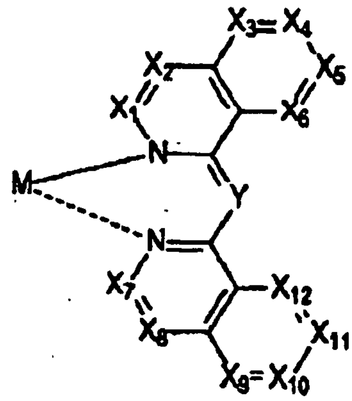

(c)

Formel 8

In Formel 8 ist aus Gründen der Übersichtlichkeit n = 1 gesetzt und nur ein Ligand an das metallische Zentralatom M koordiniert. Je nach Art des Zentralatoms M können jedoch auch weitere Liganden in der Verbindung vorhanden sein, die mit dem Zentralatom einen sechsgliedrigen metallazyklischen Ring bilden.

Weitere Beispiele für nicht erfindungsgemäße Verbindungen mit kondensierten Systemen sind in Formel 9 gezeigt. Die Formeln 9 a bis d zeigen Beispiele für Verbindungen, an denen ankondensierte Oxazolringe vorhanden sind. Die Formeln 9 e bis g zeigen Beispiele für höher kondensierte Systeme. Die Reste $R_5$ und $R_6$ in den Verbindungen gemäß den Formeln 9a bis 9d können hierbei unabhängig voneinander aus H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN ausgewählt sein. Die Positionen $X_1$ bis $X_4$ können analog Formel 8 ausgewählt sein.

In Formel 9 sind Beispiele für Fünfringe, die an in den metallazyklischen Ring eingebundene, aromatische Sechsringe annelliert sind, in dem Liganden gezeigt. In einer weiteren Ausführungsform sind auch Sechsringe, die an in den metallazyklischen Ring eingebundene, aromatische Fünfringe annelliert sind, in den Liganden möglich.

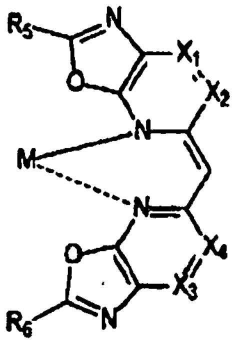

(a)

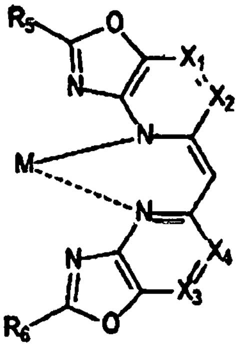

(b)

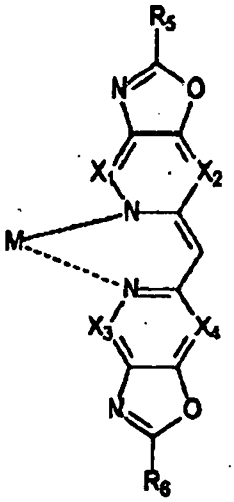

(c)

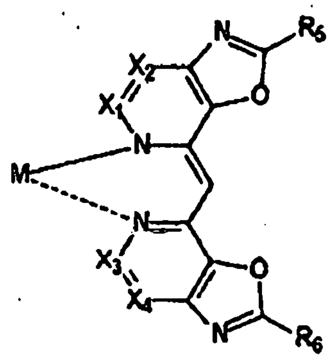

(d)

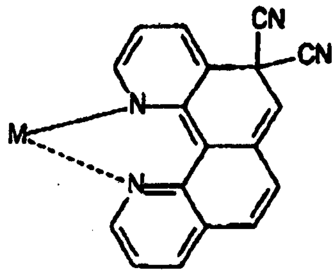

(e)

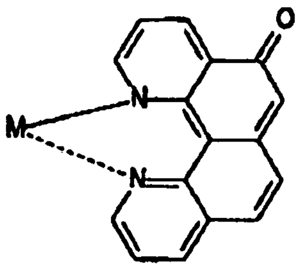

(f)

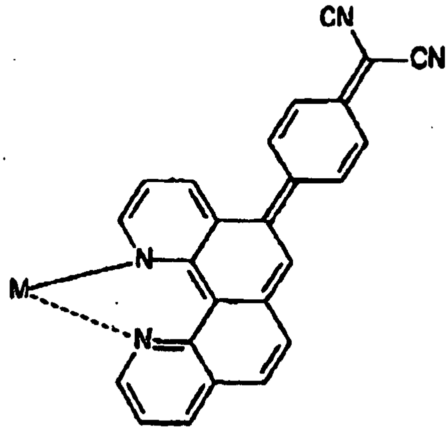

(g)

Formel 9

In einer weiteren nicht erfindungsgemäßen Ausführungsform kann die Verbindung eine Strukturformel gemäß Formel 10 aufweisen, wobei gilt:

n = 1 bis 3,
Y = C-H, N, P, As, Sb, C-$R_y$, Si-$R_y$, Ge-$R_y$,
X = N, O, P, As, Sb,
$X_1$, $X_2$, $X_5$ und $X_6$ sind - unabhängig voneinander - C oder N wenn $R_{11}$, $R_{12}$, $R_{15}$ oder $R_6$ ein freies Elektronenpaar sind,
$X_3$ und $X_7$ sind S,
Ry, $R_{11}$, $R_{12}$, $R_{15}$, und $R_6$ sind - unabhängig voneinander - H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN.

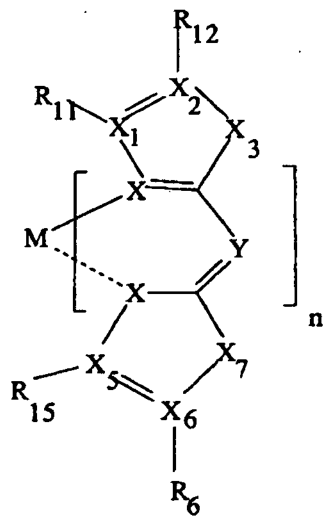

Formel 10

Beispielsweise kann eine Verbindung gemäß Formel 10 aus Bisthiazolderivaten abgeleitet werden, indem $X_1 = X_2 = X_5 = X_6 = C$, $X = N$ und $X_3 = X_7 = S$ eingesetzt wird. Für $R_{11}$ und $R_{15}$ können dann beispielsweise elektronenziehende Substituenten eingesetzt werden, die ausgewählt sind aus einer Gruppe, die CN, F, 4-Pyridyl, Triazyl, 2-Pyrimidyl, 5-Pyrimidyl, 2-Oxazol, 4-Oxazol, 2-Thiazolyl, 4-Thiazol, Trifluormethyl und Hexafluorisopropyliden umfasst.

In Verbindungen gemäß Formel 10 kann weiterhin $X_1 = X_5$, $R_{11} = R_{15}$, $X_2 = X_6$, $R_{12} = R_6$ und $X_3 = X_7$ gesetzt werden. Somit werden symmetrische Liganden erhalten. Die Reste $R_{11}$ und $R_{12}$ und/oder $R_{15}$ und $R_6$ können weiterhin miteinander verbrückt sein, was zu einer weiteren Erhöhung der Stabilität der Verbindung führt.

Sowohl die Verbindungen gemäß Formel 10, wie auch gemäß den Formeln 7 bis 9 weisen eine Azadiketonartige bzw. Diketonartige Struktur auf, die zu der Stabilität des Liganden und der farbigen Emission mit beispielsweise tiefblauer, hellblauer, blau-grüner oder grüner Emissionsfarbe der Verbindung beiträgt.

In einer weiteren nicht erfindungsgemäßen Ausführungsform kann die Verbindung eine Strukturformel aufweisen, die aus einer Gruppe ausgewählt ist, die die Strukturformeln gemäß Formel 11 umfasst, wobei gilt:

n = 1 bis 3,
Y = C-H, N, P, As, Sb, C-$R_y$, Si-$R_y$, Ge-$R_y$,
$X_1$, $X_2$, $X_3$ und $X_4$ sind - unabhängig voneinander - C-R oder N, $R_y$ und R sind - unabhängig voneinander - H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN. R kann dabei für jedes X verschieden ausgewählt sein.

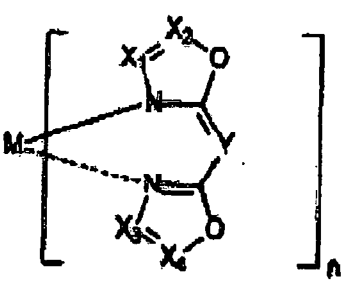

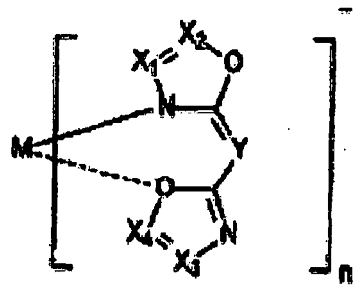

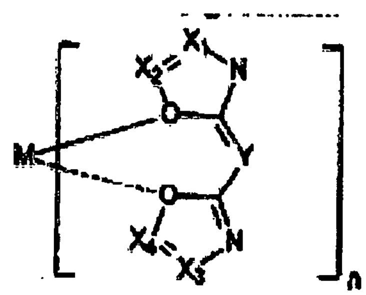

Formel 11

Diese Verbindungen weisen eine diketonartige Struktur in Fünfring-Aromaten auf. Weitere Fünfring-Aromaten im Liganden, wie beispielsweise Thiazole, Phosphazole oder Imidazole sind auch denkbar.

Es wird weiterhin ein strahlungsemittierendes Bauelement bereitgestellt, das ein Substrat, zumindest eine untere, erste Elektrodenschicht auf dem Substrat, zumindest eine organische emittierende Schicht auf der ersten Elektrodenschicht, und eine obere, zweite Elektrodenschicht umfasst, wobei in der emittierenden Schicht in einer Matrix zumindest eine Metallkomplexverbindung eingelagert ist, bei der zumindest ein Zentralatom M an zumindest einem sechsgliedrigen Metallazyklus beteiligt ist. Dabei können das Substrat und die erste Elektrodenschicht transparent sein und das Zentralatom M an zumindest einen Liganden koordiniert sein, wobei das Zentralatom und der Ligand gemäß den oben genannten Ausführungen ausgewählt sind.

In einer Ausführungsform weist die phosphoreszente Metallkomplexverbindung eine Strukturformel gemäß Formel 12 auf, wobei gilt:

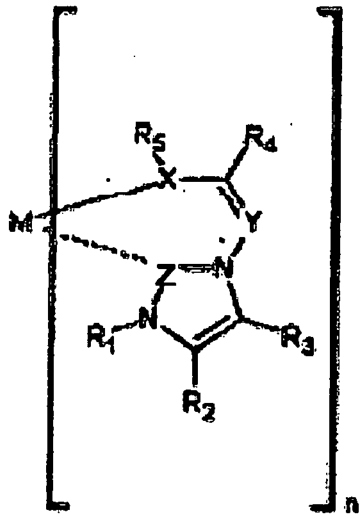

Formel 12

n = 1 bis 3,
Y = C-H, N, P, As, Sb, C-$R_y$, Si-$R_y$, Ge-$R_y$,
X = N, O, P, As, Sb,
Z = C, Si, Ge,
$R_1$, $R_2$, $R_3$, $R_y$, $R_4$ und $R_5$ sind - unabhängig voneinander - H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN. Beispielsweise können die Reste $R_1$, $R_2$, $R_3$, $R_y$, $R_4$ und $R_5$ aus einer Gruppe ausgewählt sein, die die Strukturformeln gemäß Formel 4 umfasst.

Der Ligand der Metallkomplexverbindung kann einen Carben-Liganden umfassen. Der Carben-Ligand ist über ein C-Atom und ein Heteroatom an das Zentralatom koordiniert, so dass die Carben-Struktureinheit an dem sechsgliedrigen metallazyklischen Ring beteiligt ist.

Die Verbindung gemäß Formel 12 weist eine hohe Stabilität und Lebensdauer auf. Weiterhin kann eine solche Verbindung Strahlung einer Wellenlänge emittieren, die im sichtbaren Bereich liegt und beispielsweise tiefblaues, hellblaues, blau-grünes oder grünes Licht ergibt. Weiterhin ist die Polarität in einer solchen Verbindung im Vergleich zu fünfgliedrigen metallzyklischen Verbindungen umgedreht, da das Heteroatom, z. B. ein N-Atom, anionisch und das Atom Z, beispielsweise C, neutral in den sechsgliedrigen Metallzyklus eingebunden ist.

Die beiden Reste $R_1$ und $R_5$ in Formel 12 können zusätzlich an das Zentralatom M koordiniert sein. Weiterhin können zumindest eines aus $R_1$ und $R_2$, $R_2$ und $R_3$, $R_3$ und $R_y$, $R_y$ und $R_4$ und $R_4$ und $R_5$ miteinander verbrückt sein. Eine schematische Verbrückung der Reste ist in Formel 13 gezeigt. Die einzelnen Verbrückungen $B_{45}$, $B_{23}$, $B_{4y}$ und $B_{3y}$ können unabhängig voneinander vorhanden sein.

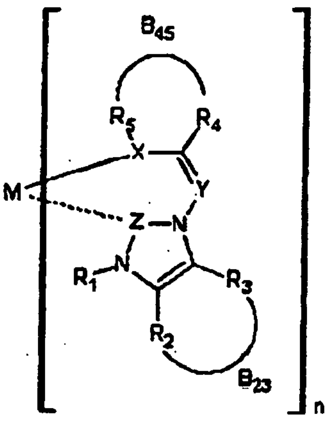

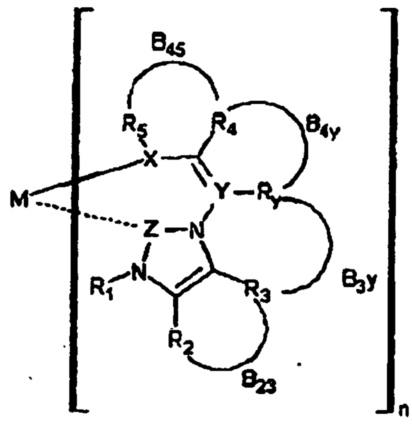

(a) (b)

Formel 13

Für die Bedeutung von X, Y, Z, $R_1$ bis $R_5$ und n in Formel 13 gelten die für die in Formel 12 gezeigte Strukturformel gezeigten Möglichkeiten analog.

Weiterhin kann die Verbindung eine Strukturformel gemäß Formel 14 aufweisen, wobei gilt:

n = 1 bis 3,
Y = C-H, N, P, As, Sb, C-$R_y$, Si-$R_y$, Ge-$R_y$,
X = N, O, P, As, Sb,
Z = C, Si, Ge,
$X_5$, $X_6$, $X_7$ und $X_8$ sind - unabhängig voneinander - C-R oder N wenn $R_{15}$, $R_6$, $R_7$ oder $R_8$ ein freies Elektronenpaar umfassen, $Z_1$, $Z_2$, $Z_3$ und $Z_4$ sind C-$R_z$, wobei $R_z$ für jedes Z unterschiedlich sein kann,
R, $R_z$, $R_1$, $R_2$, $R_3$, $R_y$, $R_4$, $R_5$, $R_{15}$, $R_6$, $R_7$, und $R_8$ sind - unabhängig voneinander - H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN.

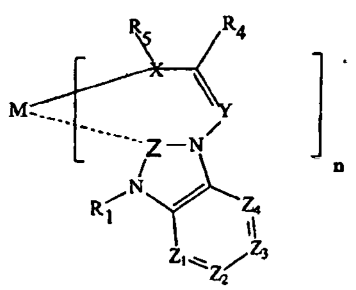

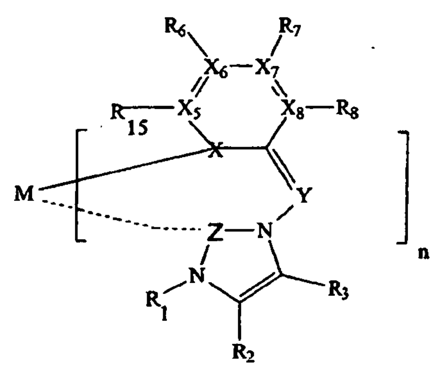

(a) (b)

Formel 14

Beispielsweise kann hier X = N und Y = C-$R_y$ eingesetzt werden.

Die Reste $R_1$ und $R_2$, $R_2$ und $R_3$, $R_5$ und $R_4$, $R_4$ und $R_y$, $R_{15}$ und $R_6$, $R_6$ und $R_7$, $R_7$ und $R_8$, $R_8$ und $R_y$ oder $R_y$ und $R_3$ können - unabhängig voneinander- miteinander verbrückt sein.

Die in Formel 14a gezeigte Struktur kann beispielsweise ein Carben-Derivat darstellen, das sich aus Benzimidazol ableitet. Dann ist Z = C, Y = C-$R_y$, X = N und $Z_1$ = $Z_2$ = $Z_3$ = $Z_4$= C-$R_z$.

In den Formeln 14a und 14b kann Z = C, Y = N oder Y = C-$R_y$ gesetzt werden. Während für Y = C-$R_y$ eine aromatische Verbrückung des Carbens mit dem sechsgliedrigen Ring über eine N-C=C- Struktureinheit vorhanden ist, ist für Y = N eine aromatische Verbrückung über eine N-C=N Struktureinheit gegeben.

Verbindungen, die eine Verbrückung aufweisen, können beispielsweise aus Pyridinderivaten abgeleitet sein. Dann ist in der Verbindung gemäß Formel 14b Z = C, Y = N, $X_5$ = $X_6$ = $X_7$ = $X_8$ = C. $R_7$ kann beispielsweise so gewählt sein, dass es elektronenziehend wirkt, wie $R_7$ = CN, F, 4-Pyridyl, Triazyl, 2-Pyrimidyl, 5-Pyrimidyl, 2-Oxazoyl, 4-Oxazoyl, 2-Thiazolyl, 4-Thiazolyl, Trifluormethyl, oder Hexafluorisporpyliden.

Ist die Verbindung gemäß Formel 14b aus Pyrazinderivaten abgeleitet, ist Z = C, Y = N, $X_5$ = $X_6$ = $X_8$ = C, $X_7$ = N und $R_7$ ist ein freies Elektronenpaar.

Aus Pyrimidin abgeleitete Verbindungen gemäß Formel 14b ergeben sich aus Z = C, Y = N, $X_5$ = $X_6$ = $X_7$ = C, $X_8$ = N und $R_8$ ist ein freies Elektronenpaar. $R_7$ kann beispielsweise elektronenziehend und aus CN, F, 4-Pyridyl, Triazyl, 2-Pyrimidyl, 5-Pyrimidyl, 2-Oxazoyl, 4-Oxazoyl, 2-Thiazolyl, 4-Thiazolyl, Trifluormethyl, oder Hexafluorisporpyliden ausgewählt sein.

Verbindungen gemäß Formel 14b, die aus Triazin abgeleitet sind, ergeben sich aus Z = C, Y = N, $X_6$ = $X_7$ = C, $X_5$ = $X_8$ = N, wobei $R_5$ und $R_8$ ein freies Elektronenpaar sind. $R_7$ kann hier elektronenziehend gewählt werden (siehe oben). Durch Permutation der N-Positionen können weitere Triazin-Derivate erhalten werden, wie beispielsweise $X_5$ = $X_6$ = C, $X_7$ = $X_8$ = N, wobei $R_7$ und $R_8$ ein freies Elektronenpaar sind und $X_5$ = $X_7$ = C, $X_6$ = $X_8$ = N, wobei $R_6$ und $R_8$ ein freies Elektronenpaar sind. $R_5$ bzw. $R_7$ können dann elektronenziehend gewählt werden.

Beispiele für kondensierte Systeme in dem Liganden sind in den Formeln 15 und 16 gezeigt. Hier sind Beispiele für Carbene (Z = C) angegeben, analoge Strukturen von Silylenen (Z = Si) oder Germylenen (Z = Ge) sind gleichermaßen denkbar. Für jedes $X_1$ bis $X_6$ kann dort C-R oder N eingesetzt werden, wobei R für jedes X unterschiedlich sein kann und R und $R_{25}$ unabhängig voneinander ausgewählt sind aus H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise·substituierte Heterocyclen, kondensierte Heterocyclen, vollständig oder teilweise substituierte Heterocyclen, F und CN. Weitere annelierte Systeme, die hier nicht gezeigt sind, können ebenso vorhanden sein.

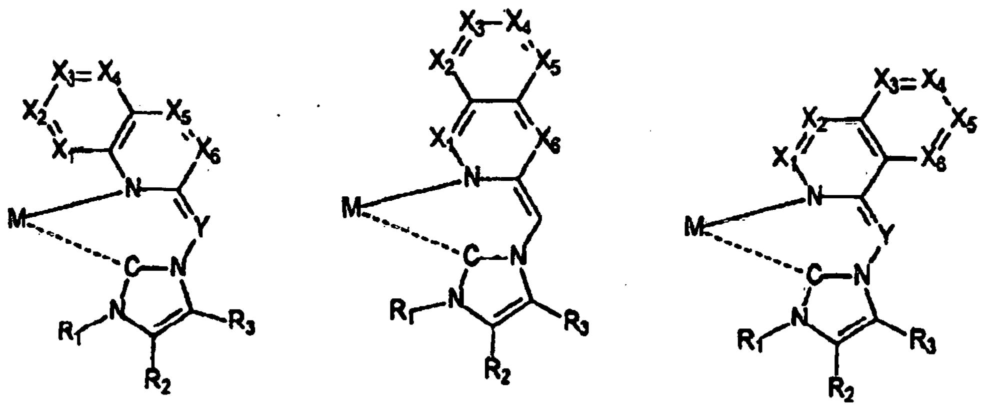

(a)

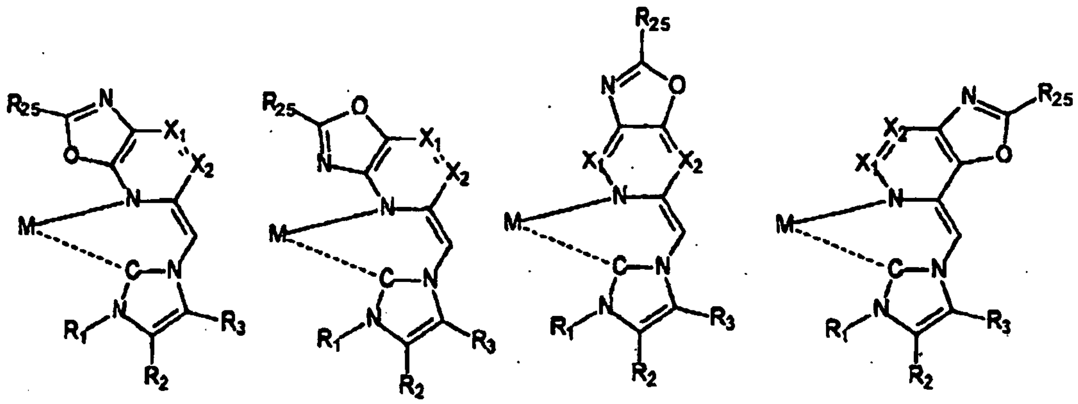

(b)

Formel 15

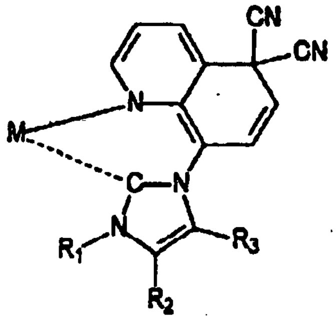

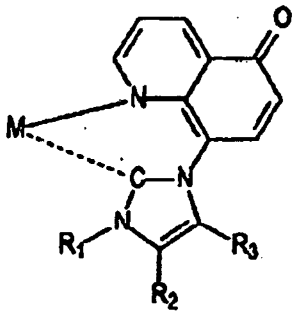

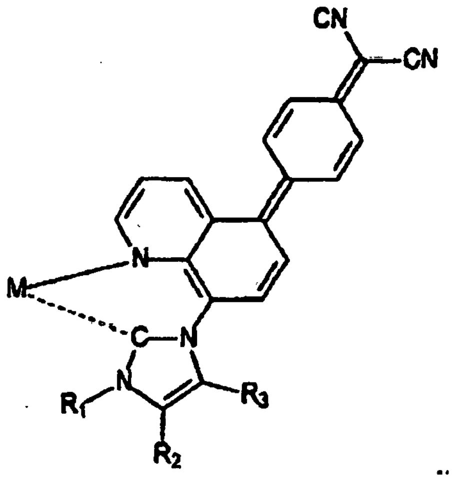

(a)

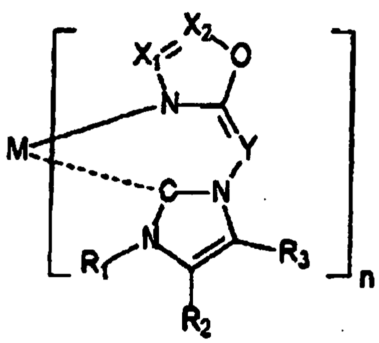

(b)

Formel 16

Formel 15a zeigt Verbindungen mit sechsglierigen annelierten Systemen in dem Carben-Liganden. Formel 15b zeigt fünfgliedrige annelierte Systeme am Beispiel von Oxazolderivaten in dem Carben-Liganden.

Formel 16a zeigt Beispiele für höher kondensierte Systeme. Der Übersicht halber ist in den Formeln 15 und

16a jeweils nur ein an das Zentralatom koordinierter Ligand gezeigt. Es können jedoch auch, je nach Wahl des Zentralatoms, mehrere Liganden vorhanden sein.

Eine Verbindung mit Carben-Ligand, der eine elektronenziehende Struktur aufweist, ist in Formel 16b gezeigt, wobei $X_1$, $X_2$, Y, n, $R_1$, $R_2$ und $R_3$ analog zu der Verbindung in Formel 14 (wobei $X_1$ und $X_2$ den dort gezeigten $X_5$, $X_6$ und $X_7$ entspricht) gewählt werden können.

Es wird weiterhin ein strahlungsemittierendes Bauelement bereitgestellt, das ein Substrat, zumindest eine untere, erste Elektrodenschicht, zumindest eine organische emittierende Schicht und darüber zumindest eine obere, zweite Elektrodenschicht umfasst, wobei in der emittierenden Schicht in einer Matrix zumindest ein Metallkomplex eingelagert ist, der zumindest ein metallisches Zentralatom M hat, das Teil eines sechsgliedrigen metallazyklischen Ringes ist, wobei in dem metallazyklischen Ring zumindest ein Carben-Ligand direkt eingebunden ist. Dabei können das Substrat und die erste Elektrodenschicht transparent ausgebildet sein.

In einer weiteren Ausführungsform kann die tautomerisierbare Einheit die Struktureinheit -C(H,R)- oder -N(H)- aufweisen und einen elektronenarmen und einen elektronenreichen Aromaten verbinden.

Die Begriffe "elektronenarm" und "elektronenreich" werden so verwendet, dass ein aromatisches Ringsystem durch Substituenten und/oder Ersatz von C-Atomen, die Teil des Ringsystems sind, durch Heteroatome derart verändert werden, dass sie im Vergleich zu den unsubstituierten bzw. nicht ersetzten Systemen, wie beispielsweise Benzol, eine erniedrigte (elektronenarm) bzw. erhöhte (elektronenreich) Elektronendichte in dem Ringsystem aufweisen.

In einer weiteren nicht erfindungsgemäßen Ausführungsform wird eine Verbindung bereitgestellt, die eine Strukturformel gemäß Formel 17 aufweist,

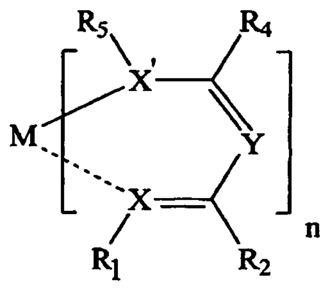

Formel 17

wobei gilt:

n = 1 bis 3,
Y = C-H, N, P, As, Sb, C-$R_y$, Si-$R_y$, Ge-$R_y$,
X und X' sind - unabhängig voneinander - N, O, P, As oder Sb, $R_1$, $R_2$, $R_4$, $R_5$ und $R_y$ sind -unabhängig voneinander- ausgewählt aus H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN, und
$R_1$ zusammen mit $R_2$ und C=X, und $R_4$ zusammen mit $R_5$ und C-X' bilden jeweils zumindest einen aromatischen Ring. Die Reste $R_1$ bis $R_5$ und $R_y$ können beispielsweise eine der Strukturformeln gemäß Formel 4 umfassen.

Formel 17 gibt nur eine mesomere Form des an das Zentralatom koordinierten Liganden an. Liegt eine andere mesomere Form vor, kann der Ligand auch eine C=X' und eine C-X Einheit umfassen, die jeweils mit den entsprechenden Resten aromatische Ringe bilden.

Eine solche Verbindung ist durch die spezielle Auswahl des Liganden oxidations- und reduktionsstabil und weist dadurch eine hohe Lebensdauer auf.

Der aromatische Ring kann aus einer Strukturformel ausgewählt sein, die aus einer Gruppe ausgewählt ist, die Strukturformeln gemäß Formel 18 umfasst.

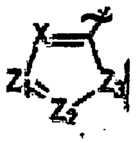

(a)

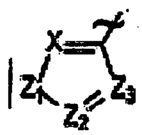

(b)

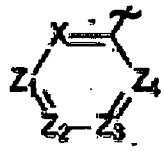

(c)

Formel 18

Dabei gilt: X = X' und ist ausgewählt aus N, O, P, As oder Sb,
$Z_1$, $Z_2$, $Z_3$ und $Z_4$ sind - unabhängig voneinander - zweibindig oder dreibindig und ausgewählt aus C-R, N wenn $Z_1$, $Z_2$, $Z_3$ und $Z_4$ dreibindig sind und ausgewählt aus O, S, N-R, Se wenn $Z_1$, $Z_2$, $Z_3$ und $Z_4$ zweibindig sind,
R ist für jedes Z unabhängig ausgewählt aus H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN.

Weiterhin kann einer der aus $R_5$, $R_4$ und C=X gebildete aromatische Ring und der aus $R_1$, $R_2$ und C-X' gebildete aromatische Ring elektronenreich und der jeweils andere aromatische Ring elektronenarm sein.

Das kann beispielsweise durch die Kombination eines fünfgliedrigen und eines sechsgliedrigen Ringes im Liganden erreicht werden. Fünfgliedrige aromatische Systeme, wie beispielsweise Pyrrole, Imidazole, Furane, Thiophene, Dithiole und Thiazole sind elektronenreich und leicht zugänglich. Ebenso elektronenreich sind nicht-heterocyclische sechsgliedrige aromatische Ringe, die mit Substituenten wie beispielsweise Alkoxy- oder Amingruppen substituiert sind. Elektronenreiche Systeme können sich als Lochleiter eignen.

Elektronenarme Systeme, die sich als Elektronenleiter eignen können, sind beispielsweise sechsgliedrige heterocyclische aromatische Systeme wie Pyridin, Pyrimidin oder Pyrazin. Benzolderivate oder fünfgliedrige aromatische Systeme können durch Fluorierung oder Nitrierung elektronenarm werden.

Werden ein elektronenarmer und ein elektronenreicher Aromat in einem Liganden über eine tautomerisierbare Einheit, wie beispielsweise die Struktureinheiten -C-(H,R)- oder -N(H)-miteinander kombiniert, werden stabile, tautomerisierbare Liganden erhalten, die unter Abspaltung eines Protons an ein metallisches Zentralatom M unter Bildung eines stabilen sechsglierigen metallazyklischen Ringes koordinieren. Diese Verbindung ist aufgrund des speziellen Liganden stabil gegen Reduktion und Oxidation, da sowohl eine hohe Lochkonzentration als auch eine hohe Elektronenkonzentration durch den Liganden ausgeglichen werden können.

Formel 19 zeigt schematisch die Tautomerisierung eines beispielhaften Liganden, in dem als tautomerisierbare Einheit -C(H,R)- und als metallisches Zentralatom M, an das der Ligand koordiniert ist, Ir gewählt ist.

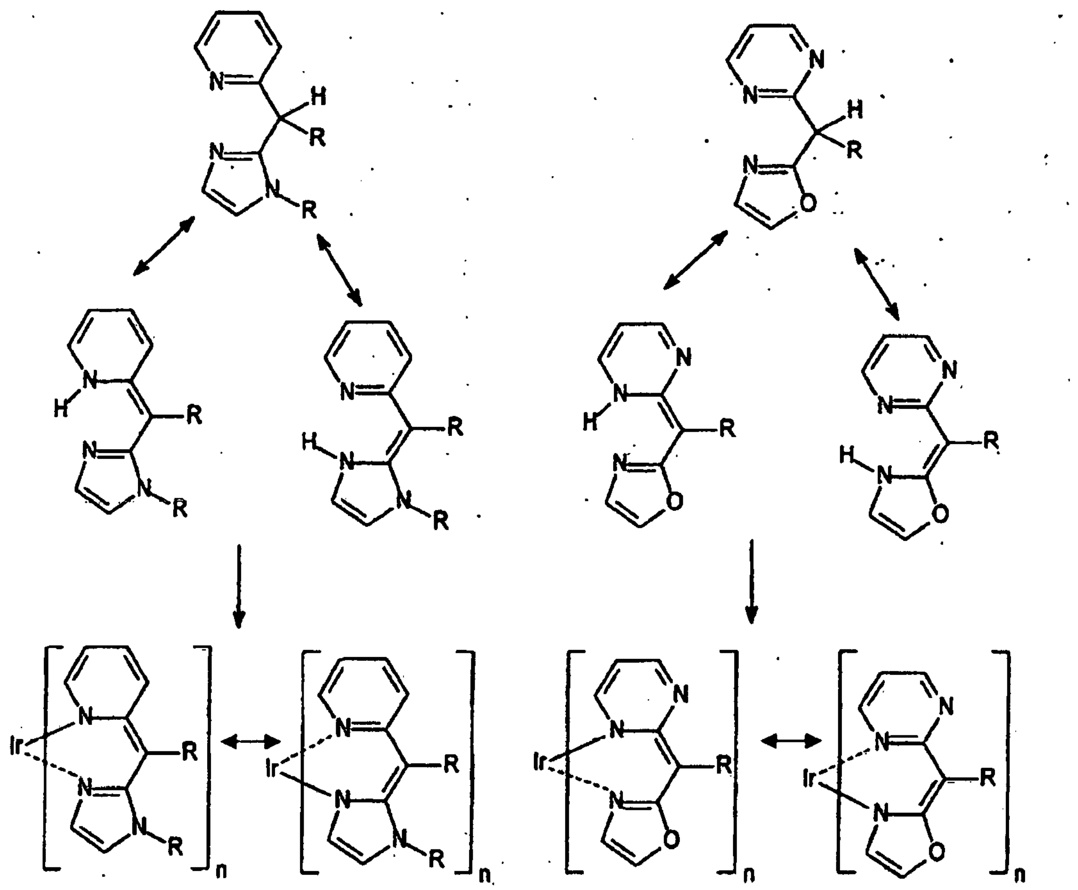

(a) (b)

Formel 19

In Formel 19 ist für zwei verschiedene Kombinationen aus elektronenarmen und elektronenreichen Aromaten im Liganden, (Formel 19a: Kombination aus Pyridin und Imidazol, Formel 19b: Kombination aus Pyrimidin und Oxazol) die verschiedenen Möglichkeiten einer Tautomerisierung gezeigt. Der tautomerisierte Ligand koordiniert an das Zentralatom, das hier beispielsweise Ir umfasst, unter Abspaltung des Protons und Bildung der Metallkomplexverbindung, die in Formel 19 in den beiden mesomeren Formen gezeigt ist (untere Strukturen in Formeln 19a und b).

Zusätzlich können auch $R_4$ und $R_y$ und/oder $R_y$ und $R_2$ der in Formel 17 gezeigten Struktur verbrückt sein. Die Verbrückungen können unabhängig voneinander auftreten.

Die Tautomerisierung von fünfgliedrigen aromatischen Ringen, die einen Teil des Liganden bilden, ist schematisch in Formel 20 gezeigt, wobei für X, Y, $Z_1$, $Z_2$ und $Z_3$ die Definitionen für die Strukturformeln der Formel 18 analog gelten.

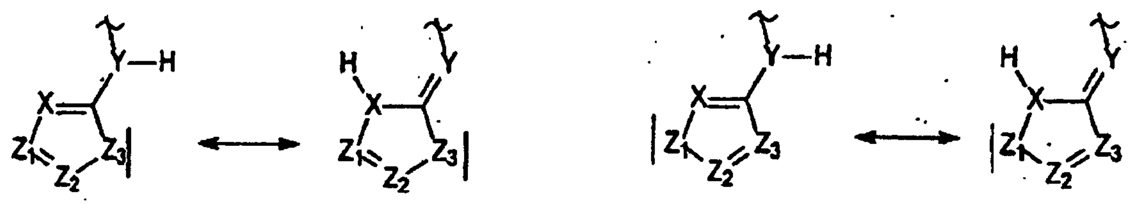

(a) (b)

Formel 20

Elektronenarme fünfgliedrige aromatische Ringe gemäß Formel 20 können beispielsweise von Oxadiazolderivaten abgeleitet sein, wenn $Z_1$= N, $Z_2$ = C-R, $Z_3$ = O und X = N. Bei einem fünfgliedrigen aromatischen Ring, der von Thiadiazolderivaten abgeleitet ist, ist $Z_1$ = N, $Z_2$ = C-R, $Z_3$ = S und X = N. Ist der fünfgliedrige Ring von s-Triazolderivaten abgeleitet, ist $Z_1$ = N, $Z_2$ = C-R, $Z_3$ = N-R und X = N. Ist der fünfgliedrige aromatische Ring von Tetrazolderivaten

abgeleitet, ist $Z_1$ = N, $Z_2$ = N, $Z_3$ = N-R und X = N.

Elektronenreiche fünfgliedrige Aromaten gemäß Formel 20 können beispielsweise von Imidazolderivaten abgeleitet sein, wenn $Z_1$ = C-R, $Z_2$ = C-R, $Z_3$ = N-R und X = N. Ist der Ring von Thiadiazolderivaten abgeleitet, ist $Z_1$ = C-R, $Z_2$ = C-R, $Z_3$ = S und X = N. Bei einem von Oxazolderivaten abgeleiteten System ist $Z_1$ = C-R, $Z_2$ = C-R, $Z_3$ = O und X = N. Von Selenazolderivaten abgeleitet, ist $Z_1$ = C-R, $Z_2$ = C-R, $Z_3$ = Se und X = N. Wenn der fünfgliedrige Ring von Oxaphospholderivaten abgeleitet ist, ist $Z_1$ = C-R, $Z_2$ = C-R, $Z_3$ = O und X = P und wenn er von Thiaphospholderivaten abgeleitet ist, ist $Z_1$ = C-R, $Z_2$ = C-R, $Z_3$ = S und X = P.

Jedes R der elektronenarmen und elektronenreichen aromatischen Ringe kann dabei -für jedes Z unterschiedlich und unabhängig voneinander- aus H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN ausgewählt sein. R kann elektronenschiebend sein und ein Amin oder eine Alkoxygruppe umfassen.

Fünfgliedrige aromatische Ringe, die elektronenarm sind, können eine wenig stabilisierende Wirkung auf die Metallkomplexverbindung und fünfgliedrige aromatische Ringe, die elektronenreich sind, eine stabilisierende Wirkung aufweisen.

Formel 21 zeigt beispielhaft die Tautomerisierung eines sechsgliedrigen aromatischen Rings, der Teil eines Liganden sein kann, wobei für X, Y, $Z_1$, $Z_2$, $Z_3$ und $Z_4$ die Definitionen für die Strukturformeln der Formel 18 analog gelten.

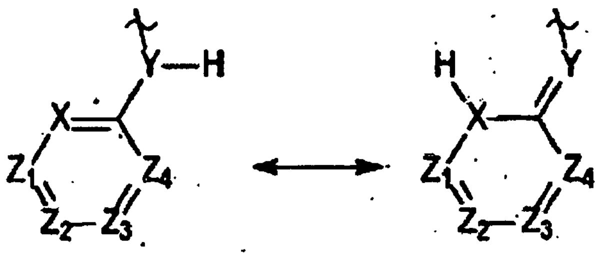

Formel 21

Der sechsgliedrige Ring kann beispielsweise elektronenarm sein und von einem Pyridinderivat abgeleitet sein, dann ist $Z_1$ = C-R, $Z_2$ = C-R, $Z_3$ = C-R, $Z_4$ = C-R und X = N. Ist der Ring von einem Pyrazinderivat abgeleitet, ist $Z_1$ = C-R, $Z_2$ = C-R, $Z_3$ = N, $Z_4$ = C-R und X = N. Bei einem von einem Pyrimidinderivat abgeleiteten sechsgliedrigen Ring ist $Z_1$ = C-R, $Z_2$ = C-R, $Z_3$ = C-R, $Z_4$ = N und X = N. Wenn der Ring von einem Triazinderivat abgeleitet ist, ist $Z_1$ = N, $Z_2$ = C-R, $Z_3$ = C-R, $Z_4$ = N und X = N oder $Z_1$ = C-R, $Z_2$ = C-R, $Z_3$ = N, $Z_4$ = N und X = N.

Jedes R kann dabei -für jedes Z unterschiedlich und unabhängig voneinander- aus H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN ausgewählt sein. R kann elektronenziehend sein und CN, F, 4-Pyridyl, Triazyl, 2-Pyrimidyl, 5-Pyrimidyl, 2-Oxazyl, 4-Oxazyl, 2-Thiazolyl, 4-Thiazolyl, Trifluormethyl und Hexafluorispropyliden umfassen.

Ist der sechsgliedrige Ring gemäß Formel 21 elektronenreich, kann er beispielsweise von einem Pyridinderivat abgeleitet sein mit $Z_1$ = C-R, $Z_2$ = C-R, $Z_3$ = C-R, $Z_4$ = C-R und X = N, wobei R Donorsubstituenten umfasst, die neben den oben genannten auch aus Methoxy, Dimethylamino sowie annellierte fünfgliedrige aromatische Systeme, wie beispielsweise Thiophen, ausgewählt sind.

Sechsgliedrige aromatische Ringe, die elektronenarm sind, können eine stabilisierende Wirkung auf die Metallkomplexverbindung aufweisen.

Es wird weiterhin ein strahlungsemittierendes Bauelement bereitgestellt, das ein Substrat, zumindest eine untere, erste Elektrodenschicht auf dem Substrat, zumindest eine organische emittierende Schicht auf der ersten Elektrodenschicht und darüber zumindest eine obere, zweite Elektrodenschicht umfasst, wobei in der emittierenden Schicht in einer Matrix zumindest eine Metallkomplexverbindung eingelagert ist, bei der zumindest ein metallisches Zentralatom

an zumindest einem metallazyklischen Ring beteiligt ist, der eine tautomerisierbare Einheit umfasst, wobei über die tautomerisierbare Einheit, die H-CR oder N-H umfassen kann, zumindest ein elektronenarmer und ein elektronenreicher Aromat verbunden ist. Weiterhin können das Substrat und die erste Elektrodenschicht transparent sein.

In einer weiteren Ausführungsform ist die phosphoreszente Metallkomplexverbindung mehrkernig und weist zumindest zwei metallische Zentralatome auf. Zumindest ein Zentralatom davon bildet einen sechsgliedrigen metallazyklischen Ring mit mindestens einem Liganden gemäß den oben genannten Ausführungen. Eine solche Verbindung weist eine hohe Stabilität und eine von dem Abstand der Zentralatome zueinander abhängige Einstellbarkeit der Emissionswellenlänge auf. Die Emissionswellenlänge kann dabei im farbigen, beispielsweise hellblauen, tiefblauen, blaugrünen oder grünen Bereich liegen. Der Abstand der Zentralatome zueinander ist durch die Wahl der Liganden sterisch kontrollierbar. Es können zwei oder mehr gleiche oder unterschiedliche Zentralatome ausgewählt werden. Beispielsweise können vier Au-Atome, die von Liganden koordiniert sind, Quadrate bilden, wobei die Ecken des Quadrats durch die Liganden gebildet werden.

Die Verbindung kann weiterhin zumindest zwei metallische Zentralatome M aufweisen, die über eine Metall-Metall-Wechselwirkung aneinander koordiniert oder miteinander verbunden sind. Die beiden Zentralatome können weiterhin über zumindest einen Brückenliganden miteinander verbunden sein. Es liegt somit keine direkte Bindung zwischen den beiden Zentralatomen vor.

Eine Metall-Metall-Wechselwirkung ist schematisch in Schema 1 dargestellt.

Das in Schema 1 gezeigte Bindungsschema stellt die Bindungsverhältnisse zwischen zwei Zentralatomen gemäß der Molekülorbital-Theorie dar. Links sind die zu besetzenden Molekülorbitale und rechts die zugehörige Bindung zu sehen.

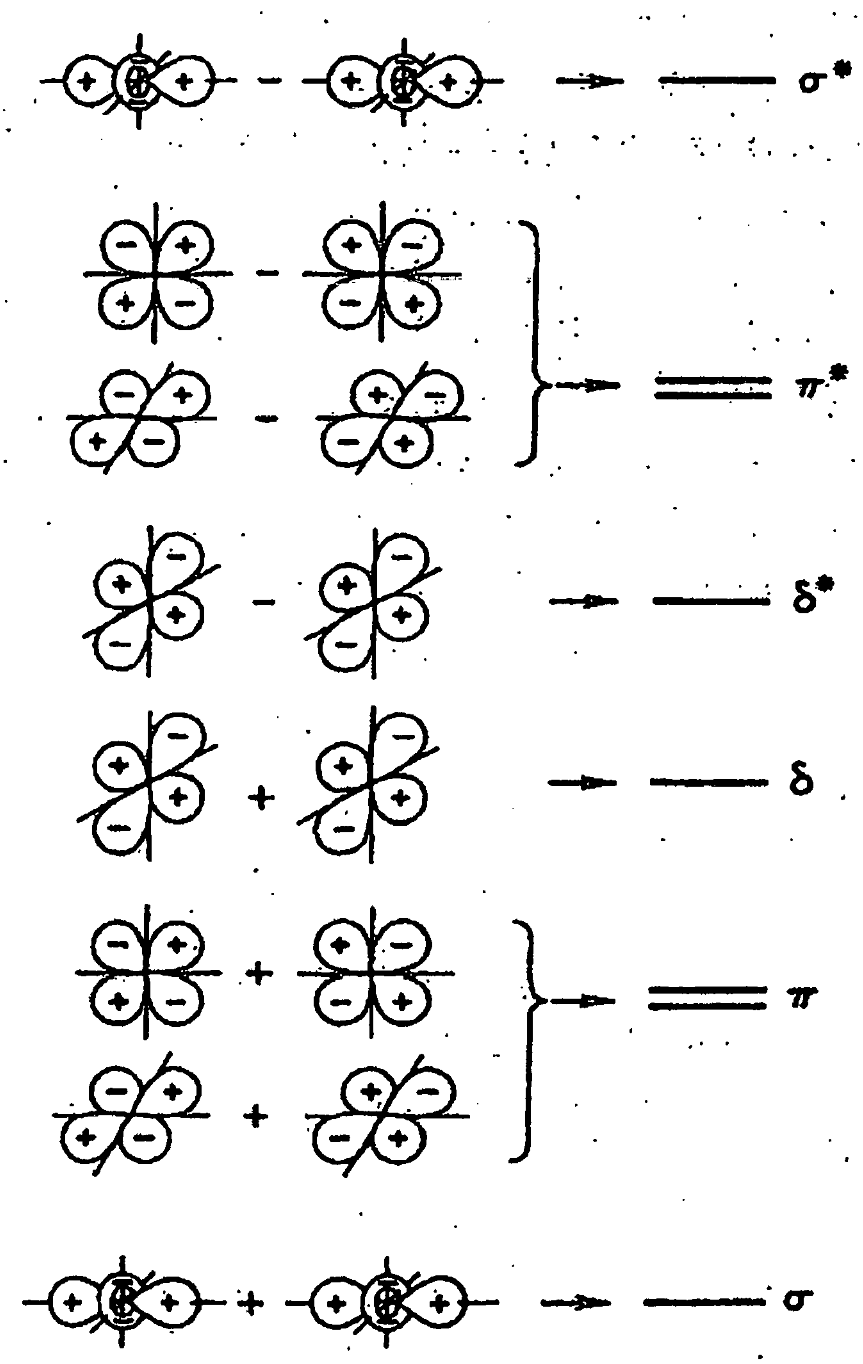


Schema 1

Betrachtet man zunächst als Beispiel das dimere Chrom(II)acetat $Cr_2(OOCH_3)_4$, ergeben sich aus den beiden Chromatomen jeweils 6 Elektronen, aus den vier Acetat-Liganden jeweils 2x2 Elektronen, insgesamt also 28 Elektronen. Damit die Chromatome jeweils die 18-Elektronen-Regel erfüllen können, also eine Konfiguration mit jeweils 18 Außenelektronen (insgesamt 36 Elektronen) erreichen, bilden sie untereinander eine vierfache Bindung aus. Damit liegt eine $\sigma^2\pi^4\delta^2$ Konfiguration vor.

Im Vergleich dazu wird ein Beispiel einer zweikernigen Metallkomplexverbindung betrachtet. Als beispielhafte Verbindung wird Phenylpyridin-Pt-(μ-pyrazol)2-Pt-phenylpyridin herangezogen. Hier liegen 2x10 Elektronen von den beiden Pt-Atomen, 2x4 Elektronen von den Pyrazol-Liganden und 2x4 Elektronen von den Phenylpyridin-Liganden, insgesamt also 36 Elektronen, vor. Damit ist die 18-Elektronen-Regel bereits für beide Pt-Atome erfüllt und es liegt eine $\sigma^2\pi^4\delta^{*2}\pi^{*4}\sigma^{*2}$ Konfiguration und damit formal keine Bindung zwischen den beiden Pt-Atomen vor, da sich die bindenden und nicht-bindenden Orbitale gegenseitig aufheben. Die beiden Pt-Atome weisen aber einen Abstand von 3 Angström auf, der durch eine signifikante Wechselwirkung zwischen den beiden Pt-Atomen bedingt ist.

Somit kann weiterhin formal betrachtet der Loch- und Elektronentransport voneinander entkoppelt werden. Der Lochtransport kann im nichtbindenden $\sigma^*$-Orbital stattfinden, während der Elektronentransport im $\pi^*$-Orbital des Liganden stattfindet. Durch den Lochtransport, der einer Oxidation entspricht, wird formal eine Bindungsordnung von 0,5 erzeugt, wodurch die Verbindung noch stabilisiert wird. Der Elektronentransport, der einer Reduktion entspricht, kann durch den sechsgliedrigen metallazyklischen Ring stabilisiert werden.

Liganden, die mit dem metallischen Zentralatom einen sechsgliedrigen Ring bilden können, wie sie in den obigen und weiteren Ausführungen beschrieben werden, sind zweizähnige Liganden, die mit zwei Bindungsatomen an das Zentralatom koordinieren. Die beiden Bindungsatome weisen dabei zueinander eine 1,5-Stellung auf.

Brückenliganden, die zwei Zentralatome miteinander verbrücken, wie in den weiteren Ausführungen beschrieben werden, sind ebenfalls zweizähnige Liganden, die mit je einem Bindungsatom an je ein Zentralatom koordinieren. Die Bindungsatome der Brückenliganden weisen zueinander eine 1,2-oder eine 1,3-Stellung auf.

Der zumindest eine Brückenligand kann aus einer Gruppe ausgewählt sein, die Guanidinderivate und Pyrazolderivate umfasst. Die Brückenliganden können beispielsweise aus 1,3,4,6,7,8-Hexahydro-2H-pyrimido[1,2-a]pyrimidin (hpp) und Pyrazol ausgewählt sein. Es sind jedoch auch weitere, Brückenliganden denkbar, die Bindungsatome aufweisen, die zueinander eine 1,2 oder 1,3-Stellung aufweisen und ausgewählt sind aus O, N und S. Beispielhafte Brückenliganden werden in "Multiple Bonds between Atoms", Cotton, Murillo, Walton, Springerverlag und in Inorg.Chem., Vol 41, No. 12, 2002, Seite 3055 genannt. Formel 22 zeigt einen hpp-Brückenliganden, in dem auch das zwischen den drei N-Atomen delokalisierte Elektron angedeutet ist. Hpp-Brückenliganden, die an zwei Zentralatome koordinieren, weisen stets ein delokalisiertes Elektron wie in Formel 22 auf. In den im Folgenden gezeigten Formeln, die hpp-Brückenliganden umfassen, gilt dies analog, auch wenn der Übersichtlichkeit halber der hpp-Ligand mit einer Doppelbindung oder ohne Doppelbindung gezeigt wird und das delokalisierte Elektron nicht angedeutet wird.

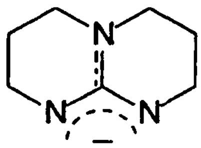

Formel 22

Weist eine mehrkernige Metallkomplexverbindung Brückenliganden auf, kann damit die Phosphoreszenz der Verbindung verstärkt werden. Beispielsweise zeigt eine Verbindung mit hpp als Brückenligand eine erhöhte Phosphoreszenz im Vergleich zu Metallkomplexverbindungen, die keine Brückenliganden aufweisen oder die keine sechsgliedrigen metallazyklischen Ringe mit Liganden aufweisen.

Die Brückenliganden können weiterhin aus den Resten $R_1$ und/oder $R_5$ der Strukturen der Formeln 3, 5, 12, 13 und 17 der Liganden gebildet sein.

In einer weiteren Ausführungsform weist die mehrkernige phophoreszente Metallkomplexverbindung zumindest zwei metallische Zentralatome auf, an die Liganden koordiniert sind, die mit einem Zentralatom einen fünfgliedrigen metallazyklischen Ring bilden, wobei die Zentralatome durch Brückenliganden miteinander verbunden sind. Die Brückenliganden können beispielsweise Guanidinderivate oder Pyrazolderivate umfassen. Diese Verbindungen können Licht einer Farbe emittieren, die beispielsweise ausgewählt ist aus tiefblau, hellblau, blau-grün und grün. Weiterhin weisen diese Verbindungen eine hohe Stabilität auf.

Es wird weiterhin ein Strahlungsemittierendes Bauelement bereitgestellt, das ein Substrat, eine erste Elektrodenschicht auf dem Substrat, zumindest eine organische emittierende Schicht auf der ersten Elektrodenschicht und eine zweite Elektrodenschicht auf der organischen emittierenden Schicht umfasst. Die organische emittierende Schicht umfasst dabei eine phosphoreszente Metallkomplexverbindung gemäß den obigen Ausführungen.

"Auf" wie es oben bereits verwendet wurde bedeutet, dass die Schichten aufeinander angeordnet sind. Es können jedoch auch noch weitere Schichten zwischen den genannten Schichten vorhanden sein.

Als weitere Schichten können beispielsweise Elektronen- oder Lochtransportschichten, Elektronen- oder Lochblockierende Schichten, Elektronen- oder Lochinjektionsschichten oder auch mehrere organische emittierende Schichten in dem Bauelement vorhanden sein.

Die Metallkomplexverbindung kann in einem Matrixmaterial vorhanden sein. Dadurch können die Konzentration an emittierendem Material in dem Matrixmaterial und die Intensität der emittierten Strahlung eingestellt werden.

Bei Anlegen einer Spannung kann das Bauelement Licht einer Farbe emittieren, die aus einer Gruppe ausgewählt ist, die tiefblau, hellblau, blau-grün und grün umfasst. Damit wird ein strahlungsemittierendes Bauelement bereitgestellt, die beispielsweise blaues Licht emittiert. Das Bauelement kann in weiteren Ausführungsformen auch Licht weiterer Farben emittieren. Umfasst das Bauelement weitere emittierende Schichten, die Licht anderer Farben emittieren, kann in Kombination mit der tiefblau, hellblau, blau-grün oder grün emittierenden Schicht ein weißes Licht emittierendes

Bauelement bereitgestellt werden.

Das Bauelement kann ein transparentes Substrat und eine transparente erste Elektrodenschicht aufweisen oder eine transparente zweite Elektrodenschicht aufweisen oder ein transparentes Substrat, eine transparente erste und eine transparente zweite Elektrodenschicht aufweisen. Je nachdem handelt es sich um ein Bottom-emittierendes, Topemittierendes oder beidseitig emittierendes Bauelement.

Bei dem strahlungsemittierenden Bauelement kann es sich beispielsweise um eine organische Licht emittierende Diode (OLED) handeln.

In einer weiteren Ausführungsform kann das Bauelement zumindest zwei Elektroden mit dazwischen einem organischen Halbleitermaterial umfassen, wobei das Halbleitermaterial blau phosphoreszierende, organische Übergangsmetallkomplexe schwerer Elemente der 8.Nebengruppe der Typen **A** und **B** umfasst, bei denen

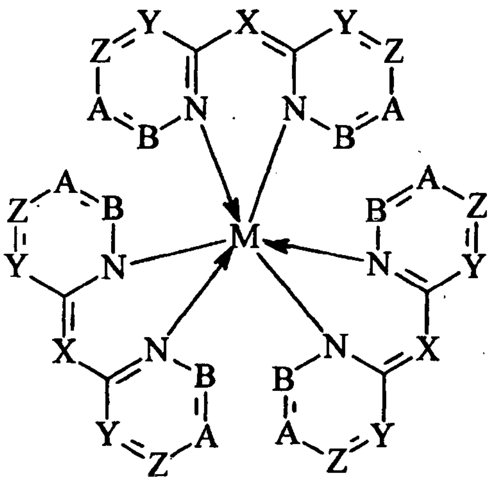

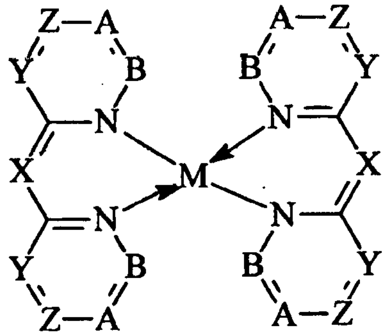

**A** **B**

Folgendes gilt:

Metall M ist in den oktaedrischen Komplexen **A** Iridium, Rhodium oder Rhenium, in den quadratischen Komplexen **B** ist Platin das Zentralatom;
die restlichen Variablen können unabhängig voneinander Stickstoff oder Kohlenstoff sein, wobei im Falle von Kohlenstoff die freie Valenz durch Wasserstoff oder einen anderen Substituenten abgesättigt ist.

Als Substituenten kommen Alkyl-, Cyano- bzw. aromatische und/oder heteroaromatische Gruppierungen in Betracht, besonders aber solche, die zwischen jeweils 2 Variablen einen kondensierten aromatischen und /oder heteroaromatischen cyclischen Substituenten bilden.

Da die Ligandenstrukturen auch als symmetrische Polymethine angesehen werden können, lassen sich die oktaedrischen Komplexe nicht in mer.- und fac.-Komplexe unterscheiden. Auch die quadratischen Platin-Komplexe weisen polymethin-artige Liganden auf.

Je geringer die $\pi$-Elektronendichte der Aromaten, umso kurzwelliger ist die Absorptions- und Emissionswellenlänge des Komplexes.

Damit können diese neuartigen phosphoreszierenden Halbleitermaterialien beispielsweise den gesamten blau emittierenden Spektralbereich abdecken. Die Halbleitermaterialien weisen eine hohe chemische, thermische und Photostabilität auf.

Besondere Stabilität entsteht in den Komplexen durch die Symmetrie der beiden Ligand-Metall-Bindungen, die mesomer sind und daher nicht unterschieden werden können.

Die Halbleitermaterialien können durch folgendes Reaktionsschema hergestellt werden:

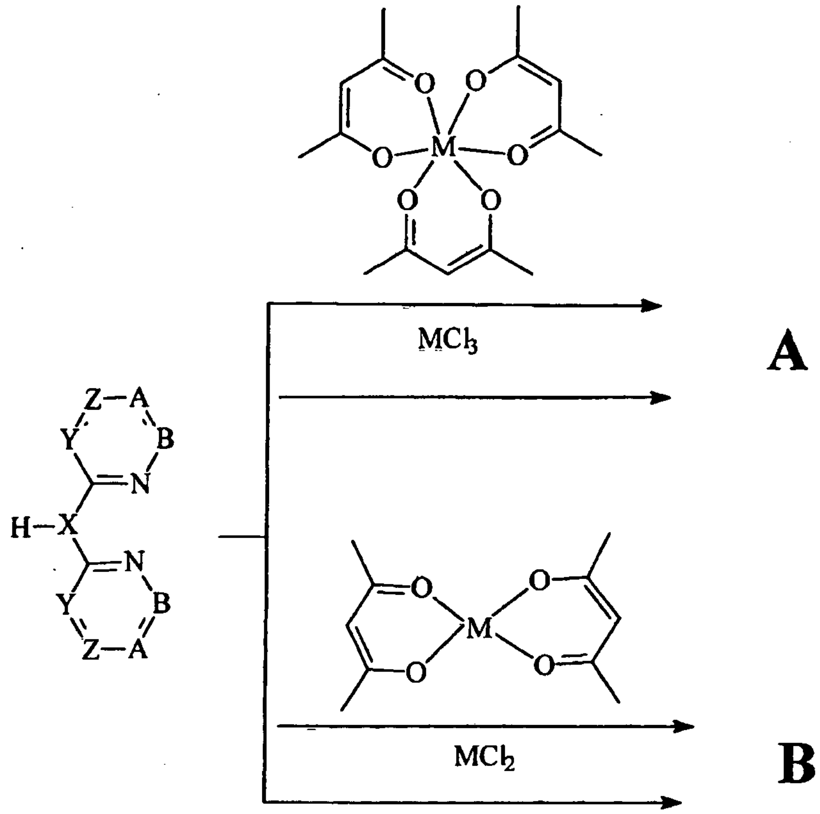


Der polymethinartige Azaaromat wird mit den jeweiligen Metallsalzen (vorzugsweise Chloriden) oder mit den Acetylacetonat-Komplexen der jeweiligen Metalle in siedenden polaren Lösemitteln, vorzugsweise in Gegenwart einer Hilfsbase wie Natriumcarbonat in stöchiometrischen Verhältnissen und Inertgasatmosphäre für 10-20h am Rückfluss erhitzt.

Durch Extraktion der mit Wasser verdünnten Reaktionsmischungen mittels Methylenchlorid oder Chloroform erhält man die Rohmaterialien, welche durch Sublimation gereinigt werden.

Es wird weiterhin ein Verfahren zur Herstellung einer phosphoreszenten Metallkomplexverbindung gemäß den obigen Ausführungen bereitgestellt. Das Verfahren umfasst die Verfahrensschritte

A) Bereitstellen einer Zentralatomverbindung eines metallischen Zentralatoms, aufweisend an das Zentralatom koordinierte Austauschliganden,

B) Mischen der Zentralatomverbindung und eines in einem ersten Lösungsmittel gelösten Liganden in einem stöchiometrischen Verhältnis zur Bildung der Metallkomplexverbindung, wobei der Austauschligand durch den Liganden ersetzt wird und der Ligand eine tautomerisierbare Einheit aufweist und mit dem Zentralatom unter Abspaltung eines Protons einen sechsgliedrigen metallazyklischen Ring bildet. In dem Verfahren können zur Abspaltung des Protons Hilfsbasen zugesetzt werden, die aus einer Gruppe ausgewählt sind, die Triethylamin, Pyridin und Alkalicarbonat umfasst.

Weiterhin kann in dem Verfahrensschritt A) die Zentralatomverbindung eines metallischen Zentralatoms in entgastem, heißem Wasser gelöst, abgekühlt und als feine Suspension kristallisiert werden. Die Abkühlung kann unter starkem Rühren erfolgen. Das heiße Wasser kann eine Temperatur von 80°C bis 100°C aufweisen und die Lösung aus Wasser und Zentralatomverbindung auf eine Temperatur von 20°C bis 30°C abgekühlt werden. Bei der Abkühlung fällt die feine Suspension aus. Durch diesen Verfahrensschritt kann eine grobkörnige Zentralatomverbindung zu einer feinkörnigen Zentralatomverbindung gemacht werden und zusätzlich Sauerstoffreste aus der Zentralatomverbindung entfernt werden. Bei der Zentralatomverbindung kann es sich beispielsweise um ein Salz und bei den Austauschliganden um Halogen-Ionen handeln.

Bei dem Salz des metallischen Zentralatoms kann es sich beispielsweise um Kaliumtetrachlorplatinat $K_2PtCl_4$ handeln. Es sind aber auch Salze mit Ir, Au, Pt, Re, Rh, Ru, Os, Pd, Ag, Zn, Al, Lanthanoiden und weiteren Metallen und Übergangsmetallen mit einer Ordnungszahl > 35, weiteren Halogen-Ionen und weiteren Kationen wie $Na^+$, $K^+$ oder $NH_4^+$ denkbar.

Weiterhin kann in dem Verfahrensschritt B) ein erstes Lösungsmittel ausgewählt werden, das mit polaren und

unpolaren Lösungsmitteln mischbar ist. Dabei kann es sich beispielsweise um Ethoxyethanol handeln. Der Ligand ist in dem ersten Lösungsmittel gelöst und ist tautomerisierbar. Wenn der Ligand an das Zentralatom koordiniert, wird dabei ein Proton von dem Liganden abgespalten. Es entsteht eine Metallkomplexverbindung, in der der Ligand Mesomerie aufweist, wie es beispielsweise in Formel 19 gezeigt ist.

Weiterhin kann in dem Verfahrensschritt B) eine einkernige Metallkomplexverbindung gebildet werden. Die Mischung aus gelöstem Liganden und der Zentralatomverbindung kann erhitzt werden, wobei sich die Metallkomplexverbindung bildet. Diese Metallkomplexverbindung weist zumindest einen Liganden auf, der mit dem Zentralatom einen sechsgliedrigen metallazyklischen Komplex bildet, wie es beispielsweise in Formel 3 gezeigt ist.

Wird eine einkernige Metallkomplexverbindung gebildet, kann das stöchiometrische Verhältnis

$$\frac{\text{Stoffmenge(Ligand)}}{\text{Stoffmenge(Zentralatomverbindung)}}$$

dem Verhältnis

$$\frac{\text{Anzahl der an das Zentralatom koordinierten Liganden}}{1}$$

entsprechen. Es werden also so viele Liganden eingesetzt, wie an das Zentralatom der einkernigen Verbindung koordiniert sein werden, damit das Zentralatom abgesättigt ist. So kann das Verhältnis

$$\frac{\text{Stoffmenge(Ligand)}}{\text{Stoffmenge(Zentralatomverbindung)}}$$

beispielsweise 2:1 sein.

In einer weiteren Ausführungsform umfasst der Verfahrensschritt B) die Verfahrensschritte

B1) Mischen der Zentralatomverbindung und eines in einem ersten Lösungsmittel gelösten Liganden in einem stöchiometrischen Verhältnis zur Bildung einer mehrkernigen Übergangskomplexverbindung,

B2) Lösen der Übergangskomplexverbindung in einem zweiten Lösungsmittel und Mischen der gelösten Übergangskomplexverbindung mit einem in einem dritten Lösungsmittel gelösten Zusatzliganden in einem stöchiometrischen Verhältnis, und

B3) Bildung der Metallkomplexverbindung unter Auflösung der Übergangskomplexverbindung. Das erste, zweite und dritte Lösungsmittel können gleich oder verschieden sein.

Die in dem Verfahrensschritt B1) gebildete Übergangskomplexverbindung kann zumindest zwei metallische Zentralatome aufweisen, an denen jeweils zumindest ein Ligand in einem sechsgliedrigen metallazyklischen Ring koordiniert ist und die über zumindest einen Austauschliganden der Zentralatomverbindung miteinander verbrückt sind. Eine solche Übergangskomplexverbindung kann beispielsweise eine Struktur gemäß Formel 23 aufweisen.

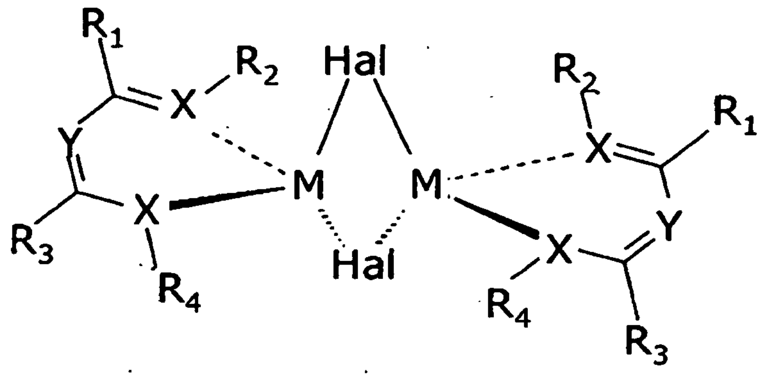

Formel 23

In Formel 23 bezeichnet Hal den Austauschliganden, beispielsweise ein Halogen-Ion, das beispielsweise Cl sein kann, das als Brückenligand zwischen zwei Zentralatomen M dient. Hal kann aber auch jeder weitere leicht austauschbare Ligand sein, beispielsweise Trifluormethansulfonat, CO oder Acetylacetonat. Die Bedeutungen von M, X, Y und $R_1$ bis $R_4$ sind analog zu den für Formel 3 angeführten Bedeutungen.

Das stöchiometrische Verhältnis

$$\frac{\text{Stoffmenge(Ligand)}}{\text{Stoffmenge(Zentralatomverbindung)}}$$

im Verfahrensschritt B1) kann dem Verhältnis

$$\frac{\text{Anzahl der in der Übergangskomplexverbindung an ein Zentralatom koordinierten Liganden}}{1}$$

entsprechen. Dieses Verhältnis kann beispielsweise 1:1 sein. Damit entspricht die Anzahl der eingesetzten Liganden, der Anzahl der Liganden, die an ein Zentralatom koordiniert sind, damit das Zentralatom abgesättigt ist, wenn zusätzlich noch zumindest ein Austauchligand an das Zentralatom koordiniert sind. In Formel 23 sind beispielsweise zwei Zentralatome M über zwei Halogen-Ionen Hal verbrückt und weisen jeweils noch einen Liganden auf, mit dem sie einen sechsgliedrigen metallzyklischen Ring bilden.

Weiterhin können in dem Verfahrensschritt B2) als zweites und drittes Lösungsmittel basische Lösungsmittel oder Lösungsmittel, denen eine Base zugesetzt wird, ausgewählt werden. Als Base kann beispielsweise $NaOR^-$, $KOR^-$ NaH oder Carbonate zugesetzt werden, wobei R einen organischen Rest umfasst. Beispielsweise kann das zweite Lösungsmittel Dichlormethan umfassen und das dritte Lösungsmittel Dichlormethan, in dem Natriummethylat gelöst ist oder mit dem Natrumethylat eine Suspension bildet. Weitere in Frage kommende zweite und/oder dritte Lösungsmittel sind Natriumbicarbonat und Triethylamin, sowie Alkoholate und Halogenkohlenwasserstoffe. Das basische dritte Lösungsmittel, in dem der Zusatzligand gelöst wird, kann eine Deprotonierung des Zusatzliganden bewirken, und damit die Koordination des Zusatzliganden an das Zentralatom ermöglichen. Die gelöste Übergangskomplexverbindung und der gelöste Zusatzligand können abgekühlt und vermischt werden und diese Mischung bei Raumtemperatur gerührt werden. Die Lösungen können beispielsweise auf eine Temperatur von -70°C abgekühlt werden und die Mischung beispielsweise 48h gerührt werden.

Weiterhin kann im Verfahrensschritt B2) ein stöchiometrisches Verhältnis

$$\frac{\text{Stoffmenge(Zusatzligand)}}{\text{Stoffmenge(Übergangskomplexverbindung)}}$$

dem Verhältnis

Anzahl der in der Übergangskomplexverbindung vorhandenen Zentralatome
1

entsprechen. Mit dieser Stoffmenge an Zusatzligand können die die Zentralatome verbrückenden Austauschliganden, beispielsweise Halogen-Ionen, durch Zusatzliganden ausgetauscht werden.

Weiterhin kann im Verfahrensschritt B2) ein Zusatzligand ausgewählt werden, der mit dem Zentralatom einen fünfgliedrigen oder sechsgliedrigen metallazyklischen Ring bildet. Damit kann eine einkernige Verbindung hergestellt werden. Es kann beispielsweise ein Ligand ausgewählt werden, der bereits im Verfahrensschritt B1) eingesetzt wird. Weitere Liganden, die mit dem Zentralatom sechsgliedrige metallazyklische Ringe bilden können, beispielsweise mit einer Struktur gemäß Formel 3, können ebenso eingesetzt werden. Beispiele für Liganden, die mit dem Zentralatom fünfgliedrige metallazyklische Ringe bilden, sind Phenylpyridinderivate, Arylimidazolderivate oder Arylcarbenderivate.

Wird im Verfahrensschritt B2) ein solcher Ligand als Zusatzligand gewählt, kann im Verfahrensschritt B3) eine einkernige Metallkomplexverbindung gebildet werden, die zumindest einen Liganden aufweist, mit dem das Zentralatom einen sechsgliedrigen metallazyklischen Ring bildet. Eine solche einkernige Metallkomplexverbindung kann beispielsweise eine Struktur gemäß Formel 3 aufweisen.

Weiterhin kann im Verfahrensschritt B2) als Zusatzligand ein Brückenligand ausgewählt werden. Damit kann eine mehrkernige Verbindung hergestellt werden, in der Zentralatome durch Brückenliganden miteinander verbunden werden. Ein Brückenligand ist beispielsweise ausgewählt aus Guanidinderivaten oder Pyrazolderivaten. Guanidinderivate können beispielsweise nach einem Herstellungsverfahren hergestellt werden, wie sie in Dalton Trans., 2006,4623-4631 offenbart sind. Auf diese Herstellungsverfahren wird hiermit vollinhaltlich Bezug genommen. Ein Brückenligand ist beispielsweise ein zweizähniger Ligand mit zwei Bindungsatomen, die in 1,2- oder 1,3-Stellung zueinander stehen. Die Ausbildung eines sechs- oder fünfgliedrigen Ringes mit einem Zentralatom ist daher nicht möglich. Somit wird die Ausbildung von beispielsweise dimeren Metallkomplexverbindungen begünstigt.

Im Verfahrensschritt B3) kann - wenn im Verfahrensschritt B2) als Zusatzligand ein Brückenligand ausgewählt wird - eine mehrkernige Metallkomplexverbindung gebildet werden, die zumindest einen Liganden umfasst, mit dem ein Zentralatom einen sechsgliedrigen metallazyklischen Ring bildet, und in der zumindest je zwei Zentralatome über zumindest einen Brückenliganden miteinander verbrückt sind. Bei entsprechender Anpassung des stöchiometrischen Verhältnisses können weiterhin auch Cluster mit mehr als zwei Zentralatomen gebildet werden.

Die Verfahrensschritte A), B), B1), B2) und B3) können in einer inerten Atmosphäre, beispielsweise in Argon- oder Stickstoff-Atmosphäre durchgeführt werden.

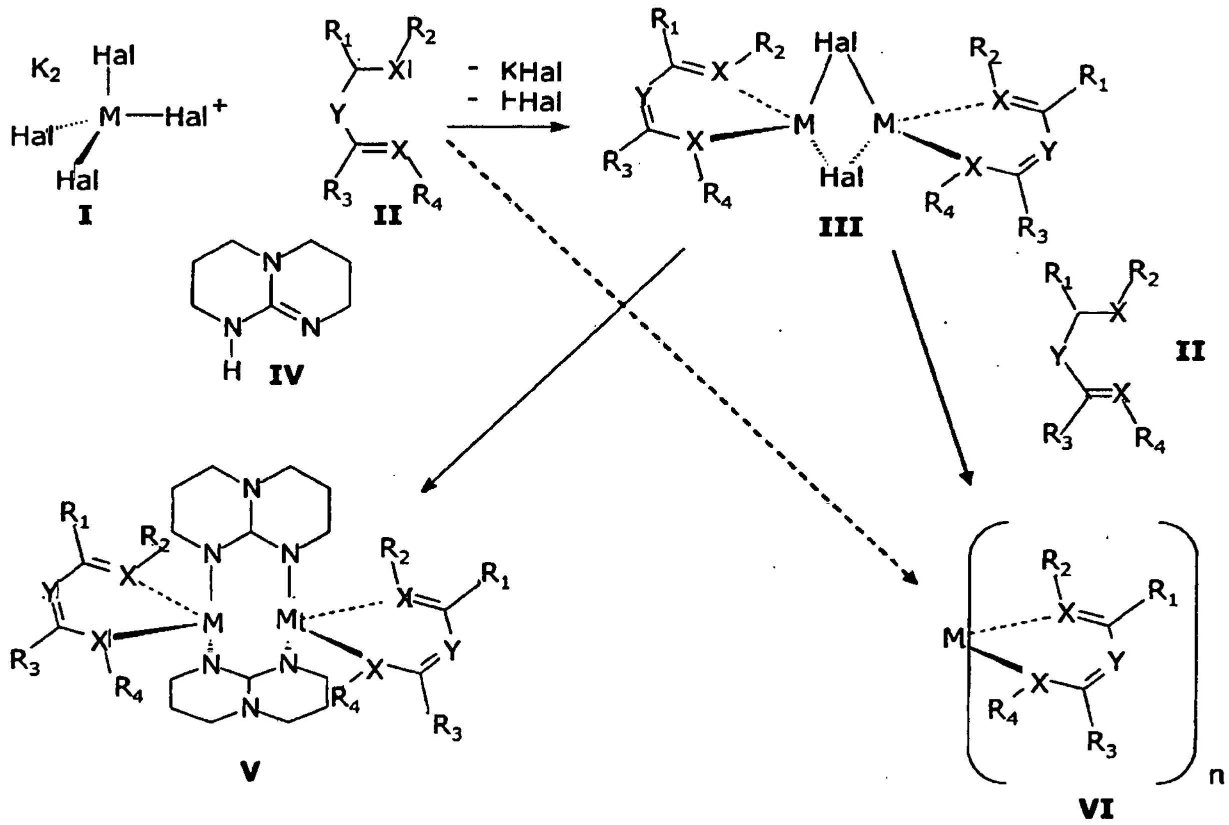


Schema 2

Schema 2 zeigt eine Syntheseroute für ein- und mehrkernige Metallkomplexverbindungen gemäß dem oben ausgeführten Verfahren. Die stöchiometrischen Verhältnisse werden in dem Schema 2 nicht angegeben, da sie je nach gewünschtem Produkt unterschiedlich sein können, wie oben ausgeführt wurde.

Als Zentralatomverbindung wird in Schema 2 beispielhaft ein Salz eines metallischen Zentralatoms angegeben, das als Austauschliganden Halogen-Ionen Hal aufweist. Statt Halogen-Ionen können weiterhin leicht austauschbare Liganden eingesetzt werden, wie beispielsweise Acetylacetonat, Trifluormethansulfonat oder CO. Das Salz I eines metallischen Zentralatoms M weist hier beispielhaft vier Halogen-Ionen Hal auf, die Anzahl der Halogen-Ionen, die an dem Zentralatom M koordiniert sind, kann jedoch je nach Bindigkeit des Zentralatoms M variieren. Ebenso kann das Verhältnis zu dem Gegenion K variieren. Das Salz I wird in einem ersten Syntheseschritt mit einem Liganden II umgesetzt. Dieser weist eine tautomerisierbare Struktureinheit Y auf, die beispielsweise $CH_2$ oder N-H sein kann. Unter Abspaltung eines Protons entsteht im Verfahrensschritt B1) eine Übergangskomplexverbindung III, die hier zwei Zentralatome M mit jeweils einem Liganden umfasst, wobei die beiden Zentralatome über zwei Halogen-Ionen miteinander verbunden sind.

Wird die Übergangskomplexverbindung III im Verfahrensschritt B2) mit einem Liganden umgesetzt, mit dem ein Zentralatom fünf- oder sechsgliedrige metallazyklische Ringe bilden kann, bildet sich im Verfahrensschritt B3) eine einkernige Metallkomplexverbindung VI. In dem Schema 2 wird als solcher Ligand der Ligand II gewählt, es ist jedoch auch möglich, einen von Ligand II verschiedenen Liganden auszuwählen. Je nach Bindigkeit des Zentralatoms können 1 bis 3 Liganden an das Zentralatom koordiniert sein, also n = 1 bis 3 sein. In Schema 2 wird beispielhaft ein Zentralatom M gewählt, an das zwei Liganden koordinieren, wie in Struktur III und V zu sehen ist.

Die einkernige Metallkomplexverbindung VI kann weiterhin direkt aus dem Salz I und dem Liganden II im Verfahrensschritt B) gebildet werden, wenn das stöchiometrische Verhältnis zwischen Salz und Ligand entsprechend angepasst wird (gestrichelter Pfeil).

Wird die Übergangskomplexverbindung III im Verfahrensschritt B2) mit einem Brückenliganden IV umgesetzt, bildet sich im Verfahrensschritt B3) eine mehrkernige Metallkomplexverbindung V. Im Schema 2 ist als Brückenligand beispielhaft ein hpp-Ligand ausgewählt, jeder andere Brückenligand kann analog eingesetzt werden. Die mehrkernige Metallkomplexverbindung weist in diesem Beispiel zwei Zentralatome M mit jeweils einem Liganden auf, die über zwei

Brückenliganden miteinander verbunden sind.

In einer weiteren Ausführungsform des Verfahrens kann im Verfahrensschritt B1) ein Ligand gewählt werden, der mit dem Zentralatom einen fünfgliedrigen metallazyklischen Ring bildet. In diesem Fall wird eine Übergangskomplexverbindung hergestellt, die Zentralatome umfasst, an die jeweils zumindest ein Ligand koordiniert ist, der mit dem Zentralatom einen fünfgliedrigen metallazyklischen Ring bildet. Diese Übergangskomplexverbindung kann im Verfahrensschritt B2) mit einem Zusatzliganden umgesetzt werden, der ein Brückenligand ist. Somit wird im Verfahrensschritt B3) eine mehrkernige Verbindung erhalten, die zumindest einen Brückenliganden aufweist und mit den Liganden fünfgliedrige metallazyklische Ringe bildet.

Anhand der Figuren und Ausführungsbeispiele sowie anhand von Vergleichsbeispielen soll die Erfindung noch näher erläutert werden.

Figur 1 zeigt die schematische Seitenansicht eines strahlungsemittierenden Bauelements.

Figur 2 zeigt ein Photolumineszenzspektrum einer Metallkomplexverbindung im Vergleich zu einem herkömmlichen Metallkomplex.

Figur 3a bis j zeigt Photolumineszenzspektren für verschiedene Metallkomplexverbindungen.

Figur 4 zeigt das a) das Absorptionsspektrum und b) das Photolumineszenz-Emissionspektrum von Tris-dipyridyliminiridium-III

Figur 5 zeigt das a) das Absorptionsspektrum und b) das Photolumineszenz-Emissionspektrum von Tris-di-1,2,4-benzotriazin-3-yl-methin-iridium-III

Beispiele für Verbindungen, die einen Carben-Liganden aufweisen, sind in Formel 24 gezeigt. Für alle dort gezeigten Verbindungen kann beispielsweise M = Ir mit n = 3 sein. Für n = 2 und M = Ir ist dann noch ein zusätzlicher Ligand, wie beispielsweise ein Picolinat-Anion, Phenylpyridin und 2-Phenylimidazol, vorhanden. Analog sind für n = 1 und M = Ir noch zwei zusätzliche Liganden vorhanden.

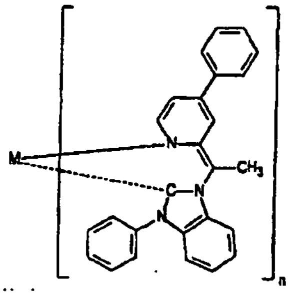
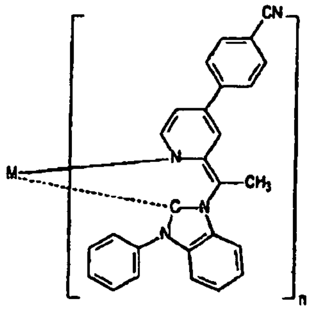
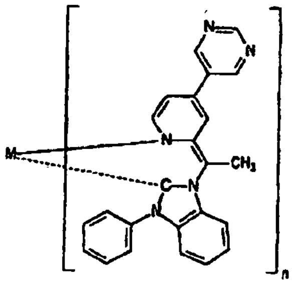
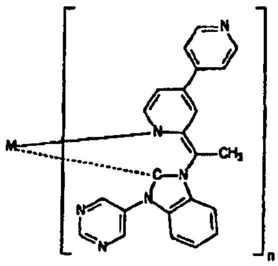
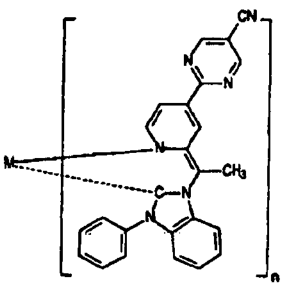
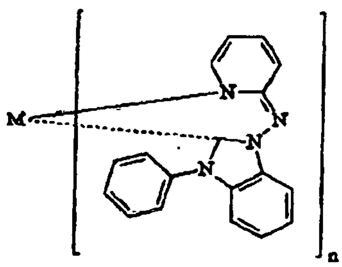
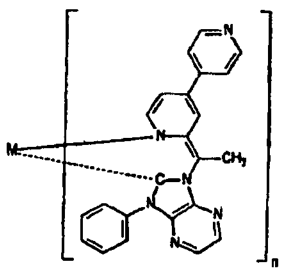

Formel 24

Beispiele für Verbindungen, die einen Liganden mit einem elektronenarmen und einem elektronenreichen aromatischen Ring aufweisen, sind in Formel 25 gezeigt. Hier ist das Zentralatom Ir, weitere Zentralatome sind ebenso geeignet.

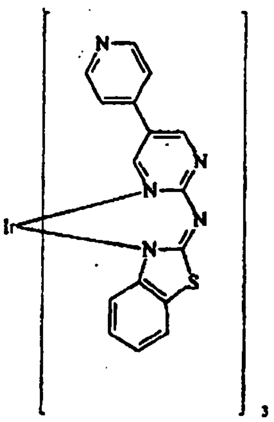

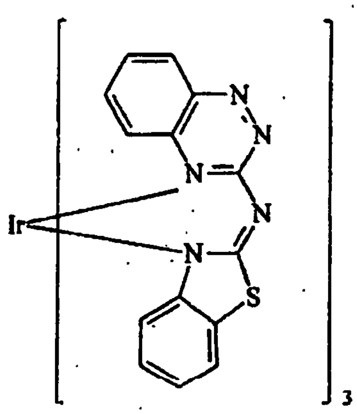

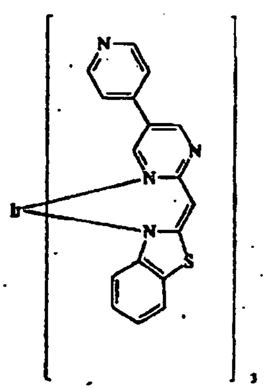

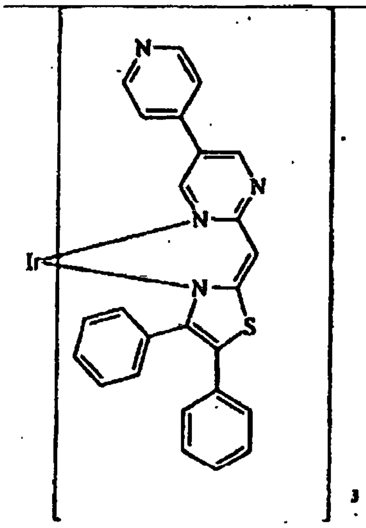

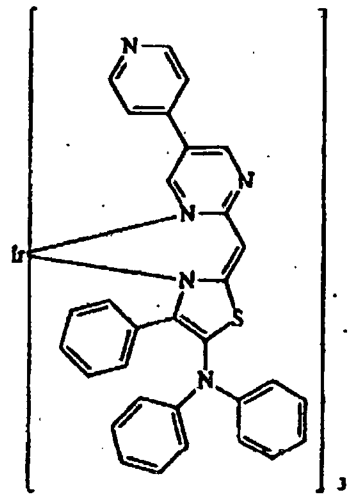

Formel 25 (Vergleichsbeispiele)

Beispiele für Verbindungen, die zweikernig sind, sind im Folgenden angegeben.

Formel 26 zeigt Beispiele für eine zweikernige Verbindung mit Pt als Zentralatome und 1,3,4,6,7,8-Hexahydro-2H-pyrimido[1,2-a]pyrimidin (a) und Pyrazol (b) als Brückenliganden, wobei für R Substituenten gemäß den oben genannten Ausführungen ausgewählt ist aus H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, vollständig oder teilweise substituierte Heterocyclen, F und CN.

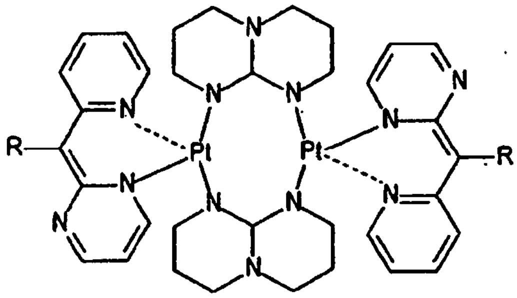

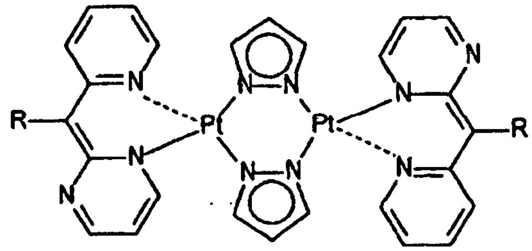

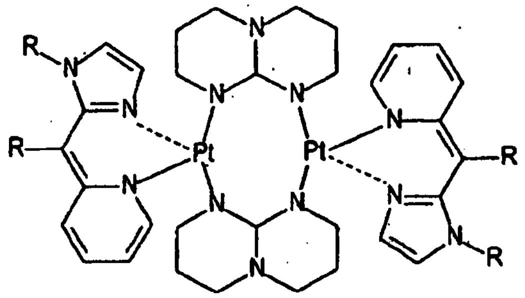

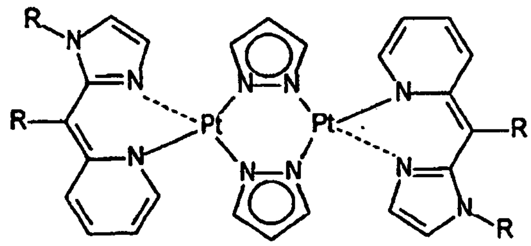

(a) (b)

Formel 26 (Vergleichsbeispiele)

Formel 27 zeigt beispielhaft Verbindungen mit Ir als Zentralatome, 1,3,4,6,7,8-Hexahydro-2H-pyrimido[1,2-a] pyrimidin (a) und Pyrazol (b) als Brückenliganden, wobei entweder zwei Brückenliganden und an jedem Ir zwei Liganden oder vier Brückenliganden und an jedem Ir ein Ligand vorhanden sein können. R kann dabei analog zu Formel 26 ausgewählt werden.

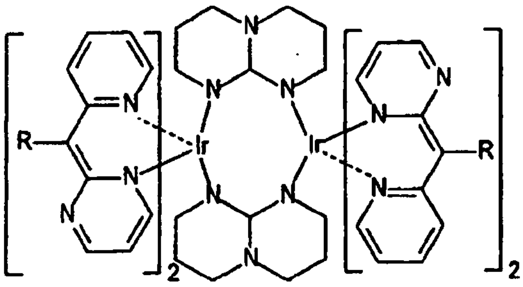
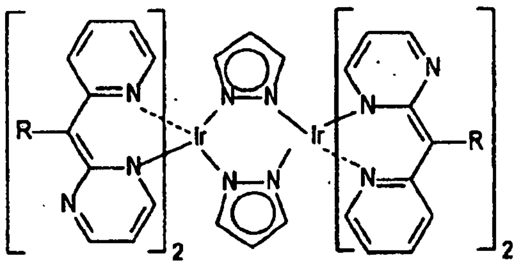
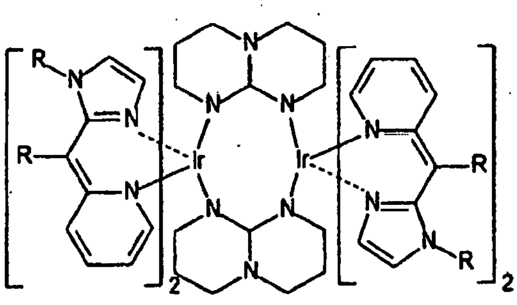
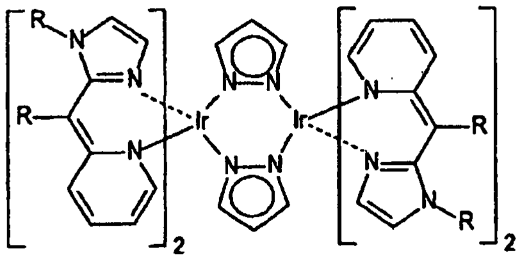
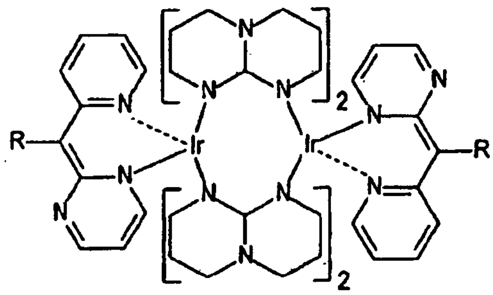
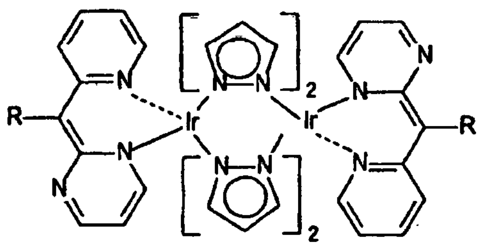
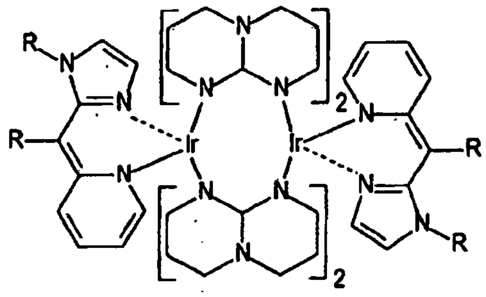
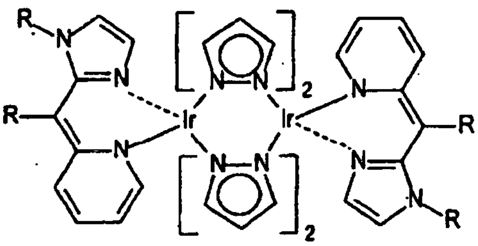

(a) (b)

Formel 27 (Vergleichsbeispiele)

Die in den Formeln 26a und 27a gezeigten Strukturformeln können als Brückenliganden auch N-C-N-Einheiten aufweisen, die in einen 5-Ring, 6-Ring oder 7-Ring integriert sind oder die ohne Ringbildung substituiert sind.

Figur 1 zeigt die schematische Seitenansicht eines strahlungsemittierenden Bauelements. Dabei ist auf einem Substrat 1, das beispielsweise aus Glas ist, eine erste Elektrodenschicht 2, die beispielsweise transparent und aus ITO (Indium Zinn Oxid) ist, angeordnet. Auf dieser Elektrodenschicht 2 ist eine Lochinjektionsschicht 3 angeordnet, auf der wiederum eine Lochtransportschicht 4 angeordnet ist. Auf der Lochtransportschicht 4 ist eine organische aktive Schicht, die organische emittierende Schicht 5 angeordnet, auf der eine lochblockierende Schicht 6, eine Elektronentransportschicht 7 und eine Elektroneninjektionsschicht 8 angeordnet sind. Auf der Elektroneninjektionsschicht 8 ist eine zweite Elektrodenschicht 9, beispielsweise eine Metallelektrode, angeordnet.

Bei Anlegen einer Spannung zwischen erster und zweiter Elektrodenschicht 2, 9 fließt Strom durch das Bauelement und in der Emissionsschicht 5 werden Photonen freigesetzt, die in Form von Licht beispielsweise über die erste Elektrodenschicht 2 und das Substrat 1 das Bauelement verlassen. Alternativ kann auch zusätzlich oder alleine die zweite Elektrodenschicht 9 transparent ausgeformt sein und das Licht das Bauelement über beide oder nur über die

zweite Elektrodenschicht verlassen.

Die Emissionsschicht 5 umfasst Metallkomplexverbindungen gemäß den oben genannten Ausführungen, die in einer Matrix eingelagert sein können.

In Figur 2 ist ein Vergleich von Photolumineszenzspektren zweier Metallkomplexverbindungen mit einem sechsgliedrigen metallazyklischen Ring gezeigt, die sich durch die Affinität des Liganden zum Zentralatom unterscheiden ((Phenylpyridyl)$_2$Ir(dipyridylamin)und(Phenylpyridyl)$_2$Ir(acety lacetonat)). Aufgetragen ist die Wellenlänge $\lambda$ in nm gegen die relative Intensität $I_{rel}$. Es ist zu erkennen, dass durch die Einführung des nucleophileren aza-analogen 1,3-Diketon-Liganden 2,2-Dipyridylamin eine Verschiebung des emittierten Lichts zu kleineren Wellenlängen um etwa 10 nm stattfindet. Die Breite der Spektren wird durch die Heteroleptizität der Komplexe erzeugt, die fünfgliedrigen Metallazyklen emittieren oberhalb 500 nm, der größer werdende Einfluß der affineren sechsgliedrigen Metallazyklen bildende Komponente (2,2-Dipyridylamin) intensiviert die Emission von blauem Licht (Wellenlängen unter 500 nm).

(Phenylpyridyl)$_2$Ir(dipyridylamin) kann aus (Phenylpyridyl)$_2$Ir(acetylacetonat) beispielsweise hergestellt werden, in dem (Phenylpyridyl)$_2$Ir(acetylacetonat) mit der äquivalenten Menge Dipyridylamin in Ethoxyethanol für 1 bis 2 min erwärmt wird, bis der orangene Farbeindruck in gelb umschlägt. Das Produkt wird nach Abkühlung abgesaugt und mit Methanol gewaschen. Diese Reaktion findet mit einer Ausbeute von 95% statt. Die Reaktion zeigt, dass die Bildung eines sechsgliedrigen metallazyklischen Rings mit tautomerisierbarer Einheit des Liganden, der mit dem Zentralatom einen aza-analogen 1,3-Diketonatkomplex bildet, aufgrund der erhöhten Nucleophilie energetisch begünstigt ist.

Alternativ kann zur Herstellung von (Phenylpyridyl)$_2$Ir(dipyridylamin) 0,1 mmol (107 mg) Phenylpyridin-di-$\mu$-chloro-iridium-III-Komplex, 0,2 mmol (35 mg) Dipyridylamin und 0,2mmol (168mg) Natriumbicarbonat in 20ml Ethoxyethanol in einem 100 ml Kolben 30 min am Rückfluß gekocht werden. Dabei fällt gelbes Produkt aus, welches abgesaugt und mit Methanol gewaschen wird (Ausbeute 75%).

Im Folgenden werden Ausführungsbeispiele und Vergleichsbeispiele zur Herstellung von Übergangskomplexverbindungen und Metallkomplexverbindungen angegeben.

Synthese von Di($\mu$-chloro)-bis[(phenyl-pyridino)platin(II)] = Verbindung 1

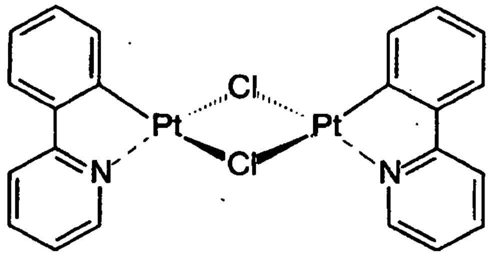

Verbindung 1 (Vergleichsbeispiel)

12 mmol (4,98 g) Kaliumtetrachloroplatinat werden in 24 ml heißem entgastem Wasser gelöst und unter starkem Rühren wieder abgekühlt. Dabei fällt das Kaliumtetrachloroplatinat als feine Suspension aus. Zu dieser Suspension wird eine Lösung von 12 mmol (1,86 g) Phenylpyridin in 72 ml Ethoxyethanol zugetropft. Die Suspension wird auf 70°C erhitzt, wobei sich zunehmend ein dunkelgrüner Niederschlag bildet. Die Suspension wird zum Ausfällen des Rohprodukts mit 30 ml Wasser unterschichtet und nach ca. 2h umgerührt. Das Rohprodukt wird abgesaugt und mehrmals mit einem Wasser/Alkohol-Gemisch (10:1) gewaschen. An dieser Stelle wird das Produkt luftstabil. Anschließend wird es im Vakuum ca. 20h getrocknet. Verschiedene Chargen zeigen im Feststoff eine gelbe bis grüne Färbung je nach Anteil an Verunreinigungen. Das Rohprodukt kann jedoch ohne weitere Reinigung für die folgenden Versuche verwendet werden.
Ausbeute: 3,56 g (77,2%)

Synthese von Di($\mu$-chloro)-bis[(2,4-difluor-phenyl-pyridino)platin(II)] = Verbindung 2

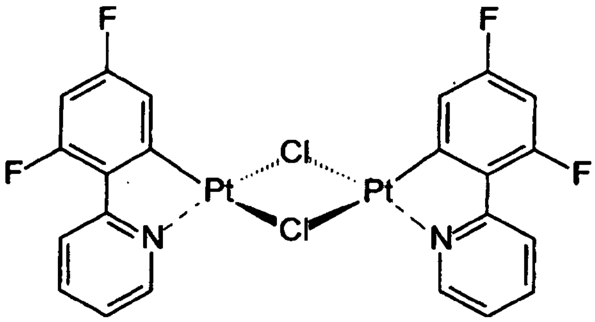

Verbindung 2 (Vergleichsbeispiel)

7,23 mmol (3 g) Kaliumtetrachloroplatinat werden in 14 ml heißem entgastem Wasser gelöst und unter starkem Rühren auf 30°C abgekühlt. Dabei fällt das Kaliumtetrachloroplatinat als feine Suspension aus. Zu dieser Suspension wird eine Lösung von 7,23 mmol (1,387g) 2,4-Difluor-phenylpyridin in 42 ml Ethoxyethanol langsam zugetropft. Die Suspension wird ca. 20h auf 70°C erhitzt, wobei sich zunehmend ein gelb-grüner Niederschlag bildet. Die Suspension wird nach Abkühlen auf Raumtemperatur zum Ausfällen des Rohprodukts mit 30 ml Wasser unterschichtet und nach ca. 2h umgerührt. Das gelb-grüne Rohprodukt wird abgesaugt und mehrmals mit einem Wasser/Alkohol-Gemisch (10:1) gewaschen. Im Exsikkator unter Vakuum ca. 20h trocknen.
Ausbeute: 2,36g (78%)

Die Verbindungen 1 und 2 zeigen die Synthese einer Übergangskomplexverbindung, wobei Liganden gewählt werden, die mit dem Zentralatom fünfgliedrige metallazyklische Ringe bilden.

Synthese von Di(μ-chloro)-bis[(di-pyridylamino)platin(II)]= Verbindung 3

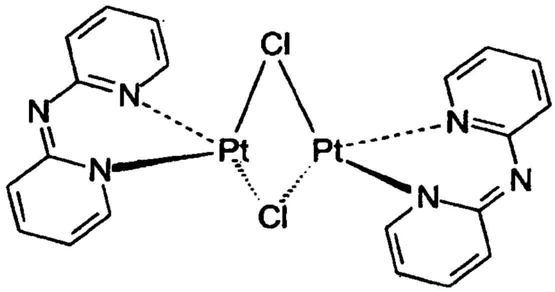

Verbindung 3 (Vergleichsbeispiel).

3 mmol (1,245 g) Kaliumtetrachloroplatinat werden in 6 ml heißem entgastem Wasser gelöst und unter starkem Rühren auf 30°C abgekühlt. Dabei fällt das Kaliumtetrachloroplatinat als feine Suspension aus. Zu dieser Suspension wird eine Lösung von 3 mmol (0,514 g) Dipyridylamin in 45 ml Ethoxyethanol langsam zugetropft. Die Suspension wird ca. 20h auf 70°C erhitzt, wobei sich zunehmend ein cremefarbener Niederschlag bildet. Die Suspension wird nach Abkühlen auf Raumtemperatur zum Ausfällen des Rohprodukts mit 40 ml Wasser unterschichtet und nach ca. 2h umgerührt. Das Rohprodukt wird abgesaugt und mehrmals mit einem Wasser/Alkohol-Gemisch (10:1) gewaschen. Im Exsikkator unter Vakuum ca. 20h trocknen.
Ausbeute: 1 g (83%)

Verbindung 3 zeigt ein Beispiel für eine Metallkomplexverbindung, die mit dem Liganden einen sechsgliedrigen metallazyklischen Ring bildet.

Synthese von Bis[(di-pyridylamino)platin(II)] = Verbindung 4

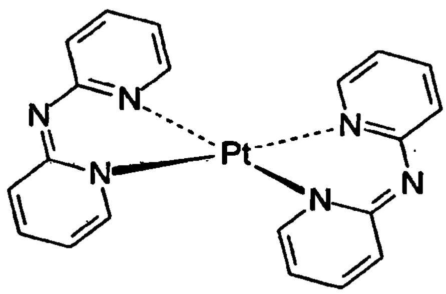

Verbindung 4 (Vergleichsbeispiel)

3 mmol (1,245 g) Kaliumtetrachloroplatinat werden in 6 ml heißem entgastem Wasser gelöst und unter starkem Rühren auf 30°C abgekühlt. Dabei fällt das Kaliumtetrachloroplatinat als feine Suspension aus. Zu dieser Suspension wird eine Lösung von 6 mmol (1,027 g) Dipyridylamin in 40 ml Ethoxyethanol langsam zugetropft. Die Suspension wird ca. 20h auf 70°C erhitzt, wobei sich zunehmend ein gelber Niederschlag bildet.

Nach dem Abkühlen wird die Mischung zweimal mit je 50 ml Wasser versetzt und unter Rühren erhitzt, um das Produkt herauszulösen. Die Wasserphase wird abgetrennt, einrotiert und das gelbe Produkt in Methanol aufgenommen und filtriert, um das entstandene Kaliumchlorid abzutrennen. Anschließend das Methanol im Vakuum abziehen.
Ausbeute: 1,37 g (85%)
Diese Verbindung kann mittels Massenspektrometrie nachgewiesen werden.

Verbindung 4 zeigt eine einkernige Metallkomplexverbindung, in der das Zentralatom mit den Liganden sechsgliedrige metallazyklische Ringe bildet. Die Figuren 3a, b, c und d zeigen Photolumineszenzspektren dieser Verbindung in verschiedenen Verdünnungen. Bei zunehmender Verdünnung verschiebt sich das Emissionsmaximum von ca. 398 nm zu 345 nm.

Synthese von Bis[(di-fluorophenylpyridin)platin(II)] = Verbindung 5

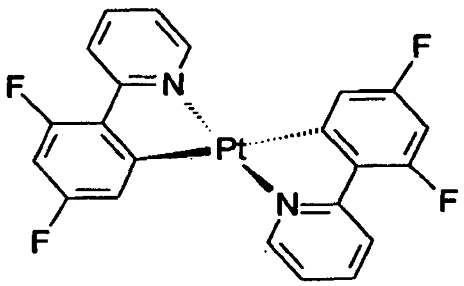

Verbindung 5 (Vergleichsbeispiel)

2,41 mmol (1 g) Kaliumtetrachloroplatinat werden in 8 ml entgastem Wasser unter starkem Rühren suspendiert. Zu dieser Suspension wird eine Lösung von 5,3 mmol (1,013 g) 2,4-difluor-Phenylpyridin in 24 ml Ethoxyethanol zugegeben. Die Suspension wird ca. 20h auf 80°C erhitzt, wobei sich zunehmend ein dunkel-grüner Niederschlag bildet. Die Suspension wird nach Abkühlen auf Raumtemperatur zum Ausfällen des Rohprodukts mit 15 ml Wasser unterschichtet und nach ca. 2h umgerührt. Das Rohprodukt wird abgesaugt und mehrmals mit einem Wasser/Alkohol-Gemisch (10:1) gewaschen. An dieser Stelle wird das Produkt luftstabil. Anschließend wird es im Vakuum ca. 20h getrocknet.
Ausbeute: 0,935 g (92%)

Verbindung 5 zeigt eine einkernige Metallkomplexverbindung, in der das Zentralatom mit den Liganden fünfgliedrige metallazyklische Ringe bildet.

Synthese von Di(μ-pyrazolato)-bis[(phenyl-pyridino)platin(II)] = Verbindung 6

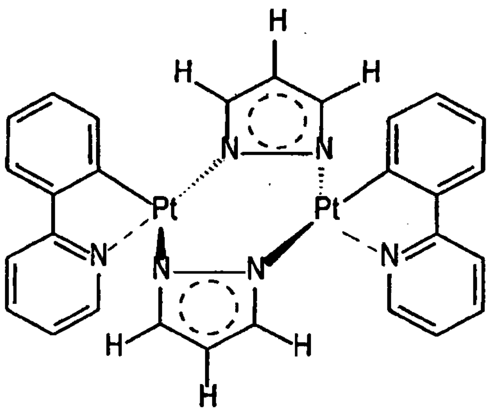

Verbindung 6 (Vergleichsbeispiel)

0, 65 mmol (0,5 g) Di(μ-chloro)-bis[(phenyl-pyridino)platin(II)] (Verbindung 1) werden in 25 ml Dichlormethan suspendiert. Gleichzeitig werden 1,3 mmol (88,5 mg) Pyrazol und 1,3 mmol (70,23 mg) Natriummethylat in 15 ml Dichlormethan ebenso suspendiert. Beide Suspensionen werden ca. 1h gerührt und dann Pyrazol-Suspension wird zu der Di(μ-chloro)-bis[(phenyl-pyridino)platin(II)]-Suspension zugegeben. Die Mischung wird ca. 48h bei Raumtemperatur gerührt. Nach 48h wird das Gemisch über eine P4-Fritte abfiltriert und mit Dichlormethan mehrmals nachgewaschen. Die Lösung wird im Vakuum eingeengt. Anschließend wird die Substanz zweimal mit Methanol gewaschen und im Vakuum getrocknet.
Ausbeute: 234 mg (43,3%)

In Figur 3e ist das Photolumineszenzspektrum der Verbindung 6 gezeigt, mit einem Emissionsmaximum bei 488 nm und 522 nm.

Synthese von Di(μ-pyrazolato)-bis[(2,4-difluor-phenyl-pyridino)platin(II)] = Verbindung 7

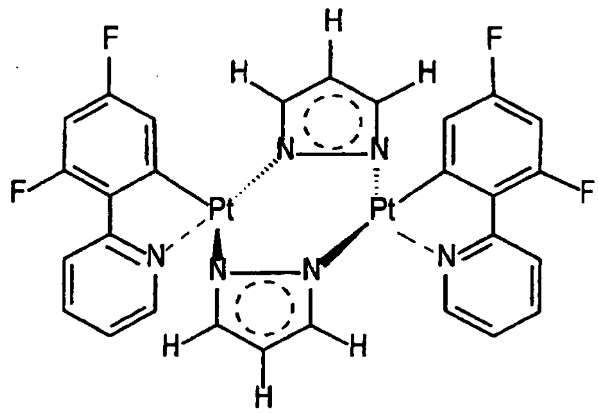

Verbindung 7 (Vergleichsbeispiel)

1, 04 mmol (874 mg) Di(μ-chloro)-bis[(2,4-difluor-phenyl-pyridino)platin(II)] (Verbindung 2) werden in 10 ml Dichlormethan suspendiert. Dazu wird eine Mischung aus 2,078 mmol (112,2 mg) Natriummethylat und 2,078 mmol (141,3 mg) Pyrazol, suspendiert in 40 ml Dichlormethan, langsam zugetropft. Die grünliche Reaktionsmischung wird 48h bei Raumtemperatur gerührt. Anschließend wird über eine Fritte filtriert und mit Dichlormethan nachgewaschen. Das Filtrat wird eingeengt und das erhaltene gelbe Produkt zweimal heiß mit Methanol und einmal mit Pentan gewaschen. Im Vakuum trocknen.
Ausbeute: 662 mg (71%)

In Figur 3f ist das Photolumineszenzspektrum der Verbindung 7 gezeigt, mit einem Emissionsmaximum bei 470 nm und 501 nm.

Synthese von Di(μ-hpp)-bis[(phenyl-pyridino)platin(II)] = Verbindung 8

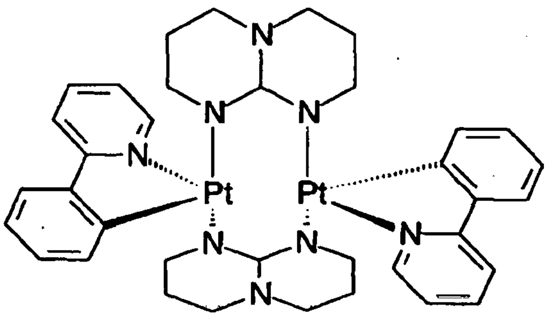

Verbindung 8 (Vergleichsbeispiel)

0,39 mmol (0,3 g) Di(μ-chloro)-bis[(phenyl-pyridino)platin(II)] (Verbindung 1) werden in 25 ml Dichlormethan suspendiert. Gleichzeitig werden 0,78 mmol (108,6 mg) Hhpp und 0,78 mmol (42,13 mg) Natriummethylat in 20 ml Dichlormethan suspendiert. Beide Suspensionen werden unter dem Rühren auf -70°C abgekühlt und dann Hhpp-Suspension wird zu der Di(μ-chloro)-bis[(phenyl-pyridino)platin(II)]-Suspension zugegeben. Die Mischung wird ca. 48h bei Raumtemperatur gerührt. Nach 48h wird das Gemisch über eine P4-Fritte abfiltriert und mit Dichlormethan mehrmals nachgewaschen. Die Lösung wird im Vakuum eingeengt. Anschließend wird die Substanz mit Pentan gewaschen. Die Pentan-Extraktion zeigt aber in Photolumineszenzspektrum das gleiche Ergebnis, wie das gewaschene Produkt.
Ausbeute: praktisch quantitativ
Diese Verbindung kann mittels Massenspektrometrie nachgewiesen werden.
In Figur 3g ist das Photolumineszenzspektrum der Verbindung 8 gezeigt, mit einem Emissionsmaximum bei 498 nm und 531 nm.

Synthese von Di(μ-hpp)-bis[(2,4-difluor-phenyl-pyridino)platin(II)] = Verbindung 9

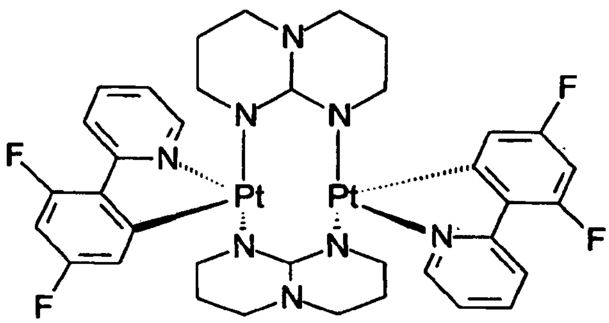

Verbindung 9 (Vergleichsbeispiel)

1,19 mmol (1 g) Di(μ-chloro)-bis[(2,4-difluor-phenyl-pyridino)platin(II)] (Verbindung 2) werden in 20 ml Dichlormethan suspendiert und auf -70°C abgekühlt. Dazu wird eine Mischung aus 2,377 mmol (128,4 mg) Natriummethylat und 2,377 mmol (330,9 mg) Hhpp, suspendiert in 40 ml Dichlormethan und ebenfalls auf -70°C gekühlt, langsam zugetropft. Die grünliche Reaktionsmischung wird 48h bei Raumtemperatur gerührt, wobei sich die Mischung bräunlich färbt. Anschließend wird über eine Fritte filtriert und mit Dichlormethan nachgewaschen. Das Filtrat wird eingeengt, man erhält ein bräunlich-beiges Produkt. Eine mit Ether herausgelöste Fraktion ergibt das gleiche PL-Spektrum wie das Rohprodukt.
Ausbeute: praktisch quantitativ
In Figur 3h ist das Photolumineszenzspektrum der Verbindung 9 gezeigt, mit einem Emissionsmaximum bei 473 nm und 501 nm.

Synthese von Di(μ-hpp)-bis[(dipyridylamino)platin(II)]= Verbindung 10

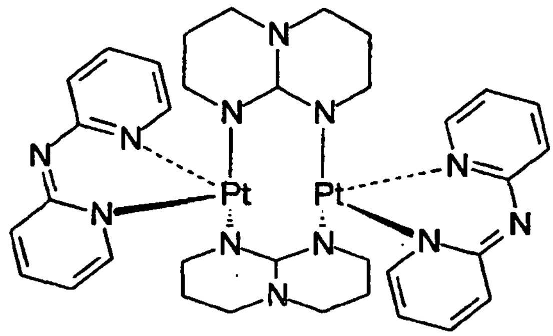

Verbindung 10 (Vergleichsbeispiel)

1,25 mmol (1 g) Di(μ-chloro)-bis[(di-pyridylamino)platin(II)] (Verbindung 3) werden in 10 ml Dichlormethan suspendiert und auf -70°C abgekühlt. Dazu wird eine Mischung aus 2,496 mmol (134,8 mg) Natriummethylat und 2,496 mmol (347,4 mg) Hhpp, suspendiert in 35 ml Dichlormethan und ebenfalls auf -70°C gekühlt, langsam zugetropft. Die Reaktionsmischung färbt sich dabei gelb. Man lässt 48h unter Rühren bei Raumtemperatur reagieren. Danach wird die Substanz durch die P4-Fritte abfiltriert und mit Dichlormethan mehrmals nachgewaschen. Das Filtrat wird eingeengt und im Vakuum getrocknet.
Ausbeute 1,04 g (83%)
Diese Verbindung kann mittels Massenspektrometrie nachgewiesen werden.

In Figur 3i ist das Photolumineszenzspektrum der Verbindung 10 gezeigt, mit einem Emissionsmaximum bei 463 nm.

Synthese von Di(μ-pyrazolato)-bis[(dipyridylamino)platin(II)] = Verbindung 11

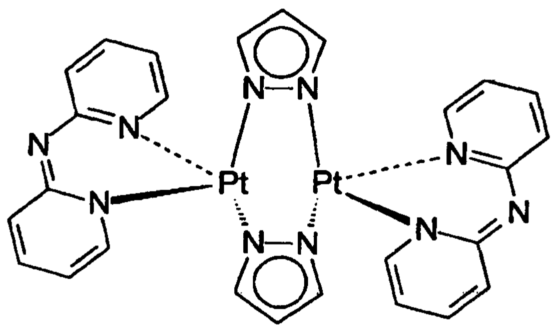

Verbindung 11 (Vergleichsbeispiel)

0,21 mmol (0,17 g) Di(μ-chloro)-bis[(di-pyridylamino)platin(II)] (Verbindung 3) werden in 15 ml Dichlormethan suspendiert. Gleichzeitig werden 0,42 mmol (28,9 mg) Pyrazol und 0,42 mmol (22,9 mg) Natriummethylat in 10 ml Dichlormethan suspendiert. Beide Suspensionen werden ca. 1h gerührt und dann wird die Pyrazol-Suspension zu der Di(μ-chloro)-bis[(di-pyridylamino)platin(II)]-Suspension zugegeben. Die Mischung wird ca. 48h bei Raumtemperatur gerührt. Die Färbung des Gemisches ist intensiv gelb. Nach 48h wird die Substanz über eine P4-Fritte abfiltriert und mit Dichlormethan mehrmals nachgewaschen. Dabei leuchtet die Lösung unter UV-Licht (384 nm) knall-grün. Anschließend wird sie im Vakuum getrocknet.
Ausbeute: 0,03 g (16,4%)

In Figur 3j ist das Photolumineszenzspektrum der Verbindung 11 gezeigt, mit einem Emissionsmaximum bei 524 nm.

Gemäß den oben genannten Synthesevorschriften sind weiterhin Metallkomplexverbindungen gemäß Formel 28 herstellbar.

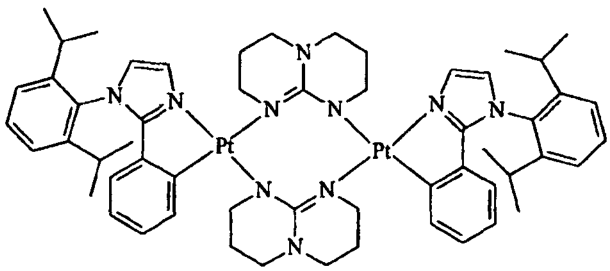

**(a)**

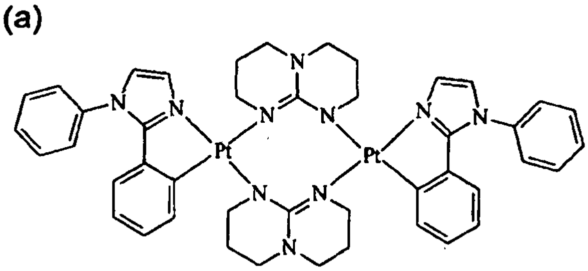

**(b)**

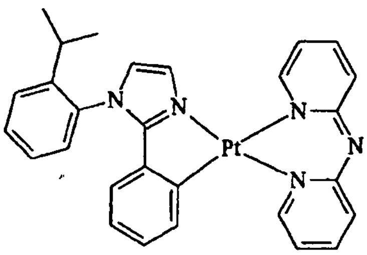

(c)

Formel 28 (Vergleichsbeispiele)

Ein weiteres Beispiel für Metallkomplexverbindungen ist Trisdipyridylimin-iridium-III (Formel 29). Dieses kann beispielsweise folgendermaßen hergestellt werden: Dipyridylamin und Iridiumacetylacetonat werden in stöchiometrischem Verhältnis in Glycol vorgelegt und unter Inertbegasung 12h am Rückfluss erhitzt. Anschließend wird die Reaktionsmischung mit Wasser versetzt und das Ir-Derivat mittels Chloroform extrahiert. Die Chloroformphase wird eingeengt und dann das Produkt durch Zugabe von Methanol gefällt.

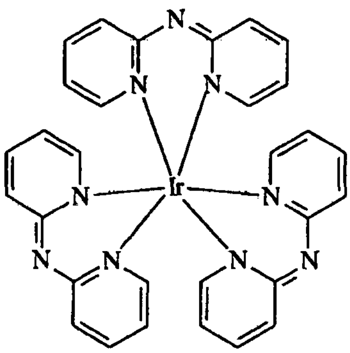

Formel 29 (Vergleichsbeispiel)

Die Figur 4a zeigt das Absorptionsspektrum (Absorption A gegen die Wellenlänge $\lambda$ in nm) von Tris-dipyridyliminiridium-III. Zu erkennen ist ein Doppelpeak um 300nm.

Figur 4b zeigt das PL-Emissionsspektrum (Intensität I gegen die Wellenlänge λ in nm) des Tris-dipyridylimin-iridium-III-Komplexes. Zu erkennen ist ein einziger Peak bei ca. 430nm.

Ein weiteres Beispiel für eine Metallkomplexverbindung ist Tris-di-1,2,4-benzotriazin-3-yl-methin-iridium-III (Formel 30), das folgendermaßen hergestellt werden kann: Dibenzo-1,2,4-triazin-3-yl-methan und Iridiumacetylacetonat werden im stöchiometrischem Verhältnis in Glycol vorgelegt und unter Inertbegasung 15h am Rückfluss erhitzt. Anschließend wird die Reaktionsmischung mit Wasser versetzt und das Ir-Derivat mittels Chloroform extrahiert. Die Chloroformphase wird eingeengt und dann das Produkt durch Zugabe von Methanol gefällt.

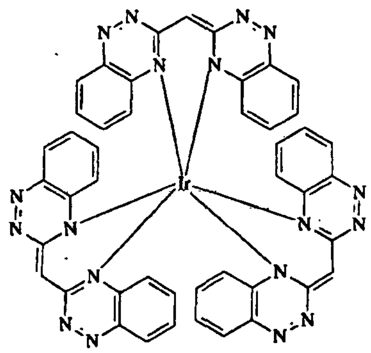

Formel 30 (Vergleichsbeispiel)

Figur 5a zeigt das Absorptionsspektrum (Absorption A gegen die Wellenlänge λ in nm) des Tris-di-1,2,4-benzotriazin-3-yl-methin-iridium-III. Zu erkennen ist ein Peak bei ca. 280 nm.

Figur 5b schließlich zeigt ein PL-Emissionsspektrum (Intensität I gegen die Wellenlänge λ in nm) des Tris-di-1,2,4-benzotriazin-3-yl-methin-iridium-III-Komplexes, zu erkennen ist ein Peak bei ca. 420 nm.

Die in Figuren 1 bis 5 gezeigten Ausführungsformen und die Ausführungsbeispiele können beliebig variiert werden. Es ist weiterhin zu berücksichtigen, dass sich die Erfindung nicht auf die Beispiele beschränkt, sondern weitere hier nicht aufgeführte Ausgestaltungen zulässt.

## Patentansprüche

1. Phosphoreszente Metallkomplexverbindung, die zumindest ein metallisches Zentralatom M und zumindest einen durch das metallische Zentralatom M koordinierten zweizähnigen Liganden umfasst, wobei

   - das eine metallische Zentralatom M und der zweizähnige Ligand einen sechsgliedrigen metallazyklischen Ring bilden,
   - der mit dem metallischen Zentralatom einen sechsgliedrigen metallazyklischen Ring bildende zweizähnige Ligand im unkoordinierten Zustand eine tautomerisierbare Einheit aufweist, und
   - das metallische Zentralatom M aus einer Gruppe ausgewählt ist, die Ir, Pt, Au, Re, Rh, Ru, Os, Pd, Ag, Zn, Al, und Lanthanoide umfasst, wobei

   die Verbindung die Strukturformel

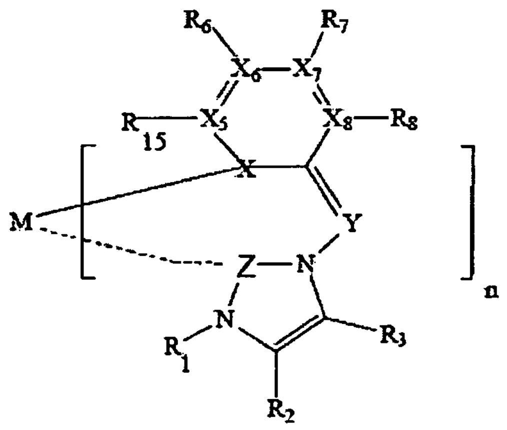

aufweist, wobei gilt:

n = 1 bis 3,
Y = C-H, N, P, As, Sb, C-$R_y$, Si-$R_y$, Ge-$R_y$,
X = N, O, P, As, Sb,
Z = C, Si, Ge,
$X_5$, $X_6$, $X_7$ und $X_8$ sind - unabhängig voneinander - C-R oder- wenn $R_{15}$, $R_6$, $R_7$ oder $R_8$ ein freies Elektronenpaar umfassen - N,
R, $R_1$, $R_2$, $R_3$, $R_y$, $R_{15}$, $R_6$, $R_7$, und $R_8$ sind - unabhängig voneinander - H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, F und CN.

2. Verbindung nach dem vorhergehenden Anspruch, wobei der Ligand ein Carben-Ligand ist.

3. Verbindung nach dem vorhergehenden Anspruch, wobei zumindest eines aus $R_1$ und $R_2$, $R_2$ und $R_3$, $R_{15}$ und $R_6$, $R_6$ und $R_7$, $R_7$ und $R_8$, $R_8$ und $R_y$ oder $R_y$ und $R_3$ miteinander verbrückt sind.

4. Verbindung nach Anspruch 1, wobei die tautomerisierbare Einheit eine Struktureinheit aufweist, die ausgewählt ist aus -C(H,R)- oder -N(H)-, und einen elektronenarmen und einen elektronenreichen Aromaten verbindet.

5. Verbindung nach einem der vorhergehenden Ansprüche, die mehrkernig ist und zumindest zwei metallische Zentralatome M aufweist.

6. Verbindung nach dem vorhergehenden Anspruch, wobei die zumindest zwei metallischen Zentralatome M über eine Metall-Metall-Wechselwirkung miteinander verbunden sind.

7. Verbindung nach einem der Ansprüche 5 oder 6, wobei die zumindest zwei metallischen Zentralatome M über zumindest einen zusätzlichen Brückenliganden verbunden sind.

8. Strahlungsemittierendes Bauelement, umfassend

- ein Substrat,
- eine erste Elektrodenschicht auf dem Substrat,
- zumindest eine organische emittierende Schicht auf der ersten Elektrodenschicht, und
- eine zweite Elektrodenschicht auf der organischen emittierenden Schicht,

wobei die organische emittierende Schicht eine phosphoreszente Metallkomplexverbindung umfasst, wobei die

phosphoreszente Metallkomplexverbindung zumindest ein metallisches Zentralatom M und zumindest einen durch das metallische Zentralatom M koordinierten zweizähnigen Liganden umfasst,
- wobei das eine metallische Zentralatom M und der zweizähnige Ligand einen sechsgliedrigen metallazyklischen Ring bilden,
- wobei der mit dem metallischen Zentralatom einen sechsgliedrigen metallazyklischen Ring bildende zweizähnige Ligand im unkoordinierten Zustand eine tautomerisierbare Einheit aufweist, und
- wobei das metallische Zentralatom M aus einer Gruppe ausgewählt ist, die Ir, Pt, Au, Re, Rh, Ru, Os, Pd, Ag, Zn, Al, und Lanthanoide umfasst, wobei
die Verbindung die Strukturformel

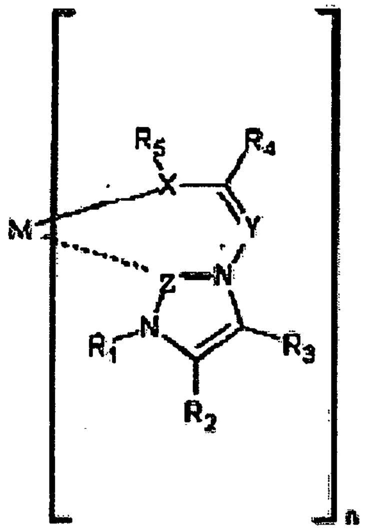

aufweist, wobei gilt:

n = 1 bis 3,
Y = C-H, N, P, As, Sb, C-$R_y$, Si-$R_y$, Ge-$R_y$,
X = N, O, P, As, Sb,
Z = C, Si, Ge,
$R_1$, $R_2$, $R_3$, $R_y$, $R_4$ und $R_5$ sind - unabhängig voneinander - H, unverzweigte Alkylreste, verzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, kondensierte Aromaten, vollständig oder teilweise substituierte kondensierte Aromaten, Heterocyclen, vollständig oder teilweise substituierte Heterocyclen, kondensierte Heterocyclen, F und CN.

**9.** Verfahren zur Herstellung einer phosphoreszenten Metallkomplexverbindung gemäß den Ansprüchen 1 bis 7 mit den Verfahrensschritten

A) Bereitstellen einer Zentralatomverbindung eines metallischen Zentralatoms, aufweisend an das Zentralatom koordinierte Austauschliganden,
B) Mischen der Zentralatomverbindung und eines in einem ersten Lösungsmittel gelösten Liganden in einem stöchiometrischen Verhältnis zur Bildung der Metallkomplexverbindung,
wobei der Austauschligand durch den Liganden ersetzt wird und der Ligand eine tautomerisierbare Einheit aufweist und mit dem Zentralatom unter Abspaltung eines Protons einen sechsgliedrigen metallazyklischen Ring bildet.

## Claims

1. Phosphorescent metal complex which comprises at least one metallic central atom M and at least one bidentate ligand coordinated by the metallic central atom M, wherein

   - the metallic central atom M and the bidentate ligand form a six-membered metallacyclic ring
   - the bidentate ligand which forms a six-membered metallacyclic ring with the metallic central atom has a tautomerizable unit in the uncoordinated state, and
   - the metallic central atom M is selected from a group which comprises Ir, Pt, Au, Re, Rh, Ru, Os, Pd, Ag, Zn, Al and lanthanoids, wherein
   the complex has the structural formula

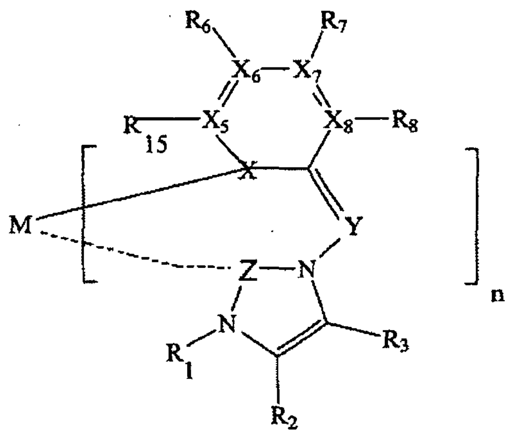

   where:

   n = 1 to 3,
   Y = C-H, N, P, As, Sb, C-$R_y$, Si-$R_y$, Ge-$R_y$,
   X = N, O, P, As, Sb,
   Z = C, Si, Ge,
   $X_5$, $X_6$, $X_7$ and $x_8$ are each independently C-R or - when $R_{15}$, $R_6$, $R_7$ or $R_8$ includes a free electron pair - N,
   R, $R_1$, $R_2$, $R_3$, $R_y$, $R_{15}$, $R_6$, $R_7$ and $R_8$ are each independently H, unbranched alkyl radicals, branched alkyl radicals, fused alkyl radicals, cyclic alkyl radicals, fully or partly substituted unbranched alkyl radicals, fully or partly substituted branched alkyl radicals, fully or partly substituted fused alkyl radicals, fully or partly substituted cyclic alkyl radicals, alkoxy groups, amines, amides, esters, carbonates, aromatics, fully or partly substituted aromatics, fused aromatics, fully or partly substituted fused aromatics, heterocycles, fully or partly substituted heterocycles, fused heterocycles, F and CN.

2. Complex according to the preceding claim, wherein the ligand is a carbene ligand.

3. Complex according to the preceding claim, wherein at least one of $R_1$ and $R_2$, $R_2$ and $R_3$, $R_{15}$ and $R_6$, $R_6$ and $R_7$, $R_7$ and $R_8$, $R_8$ and $R_y$ or $R_y$ and $R_3$ are bridged to one another.

4. Complex according to Claim 1, wherein the tautomerizable unit has a structural unit which is selected from -C(H,R)- or -N(H)-, and connect an electron-deficient and an electron-rich aromatic.

5. Complex according to any of the preceding claims, which is polynuclear and has at least two metallic central atoms M.

6. Complex according to the preceding claim, wherein the at least two metallic central atoms M are bonded to one another via a metal-metal interaction.

7. Complex according to either of Claims 5 and 6, wherein the at least two metallic central atoms M are joined via at

least one additional bridging ligand.

**8.** Radiation-emitting component comprising

- a substrate,
- a first electrode layer on the substrate,
- at least one organic emitting layer on the first electrode layer, and
- a second electrode layer on the organic emitting layer,
- wherein the organic emitting layer comprises a phosphorescent metal complex, wherein the phosphorescent metal complex comprises at least one metallic central atom M and at least one bidentate ligand coordinated by the metallic central atom M,
- wherein the metallic central atom M and the bidentate ligand form a six-membered metallacyclic ring,
- wherein the bidentate ligand which forms a six-membered metallacyclic ring with the metallic central atom has a tautomerizable unit in the uncoordinated state, and
- wherein the metallic central atom M is selected from a group which comprises Ir, Pt, Au, Re, Rh, Ru, Os, Pd, Ag, Zn, Al and lanthanoids, wherein

the complex has the structural formula

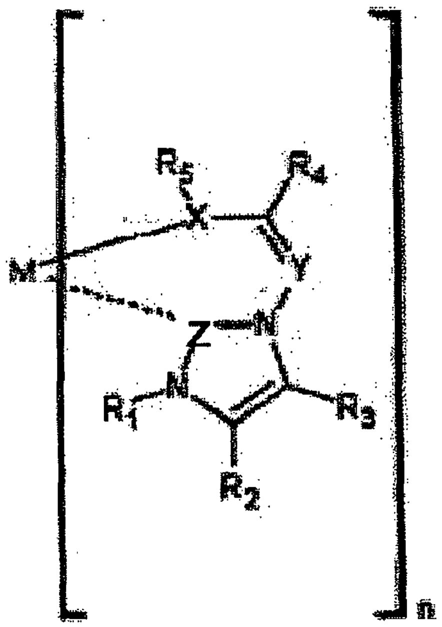

where:

n = 1 to 3,
Y = C-H, N, P, As, Sb, C-$R_y$, Si-$R_y$, Ge-$R_y$,
X = N, O, P, As, Sb,
Z = C, Si, Ge,
$R_1$, $R_2$, $R_3$, $R_y$, $R_4$ and $R_5$ are each independently H, unbranched alkyl radicals, branched alkyl radicals, fused alkyl radicals, cyclic alkyl radicals, fully or partly substituted unbranched alkyl radicals, fully or partly substituted branched alkyl radicals, fully or partly substituted fused alkyl radicals, fully or partly substituted cyclic alkyl radicals, alkoxy groups, amines, amides, esters, carbonates, aromatics, fully or partly substituted aromatics, fused aromatics, fully or partly substituted fused aromatics, heterocycles, fully or partly substituted heterocycles, fused heterocycles, F and CN.

**9.** Process for preparing a phosphorescent metal complex according to Claims 1 to 7, comprising the process steps of

A) providing a central atom compound of a metallic central atom, having exchange ligands coordinated to the

central atom,
B) mixing the central atom compound and a ligand dissolved in a first solvent in a stoichiometric ratio to form the metal complex,
wherein the exchange ligand is replaced by the ligand and the ligand has a tautomerizable unit and forms a six-membered metallacyclic ring with the central atom with elimination of a proton.

**Revendications**

1. Composé de complexe métallique phosphorescent, qui comprend au moins un atome métallique central M et au moins un ligand bidenté coordonné par l'atome métallique central M,

- l'un atome métallique central M et le ligand bidenté formant un cycle métallacyclique à six éléments,
- le ligand bidenté qui forme un cycle métallacyclique à six éléments avec l'atome métallique central comprenant à l'état non coordonné une unité tautomérisable, et
- l'atome métallique central M étant choisi dans un groupe qui comprend Ir, Pt, Au, Re, Rh, Ru, Os, Pd, Ag, Zn, Al et les lanthanides,

le composé présentant la formule structurale

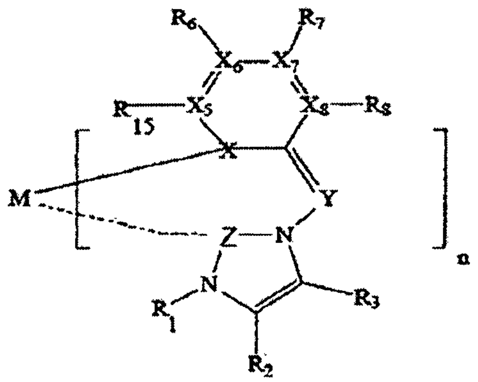

dans laquelle :

n = 1 à 3,
Y = C-H, N, P, As, Sb, C-$R_y$, Si-$R_y$, Ge-$R_y$,
X = N, O, P, As, Sb,
Z = C, Si, Ge,
$X_5$, $X_6$, $X_7$ et $X_8$ représentent, indépendamment les uns des autres, C-R ou, lorsque $R_{15}$, $R_6$, $R_7$ ou $R_8$ comprennent une paire d'électrons libres, N,
R, $R_1$, $R_2$, $R_3$, $R_y$, $R_{15}$ $R_6$, $R_7$ et $R_8$ représentent, indépendamment les uns des autres, H, des radicaux alkyle non ramifiés, des radicaux alkyle ramifiés, des radicaux alkyle condensés, des radicaux alkyle cycliques, des radicaux alkyle non ramifiés substitués en totalité ou en partie, des radicaux alkyle ramifiés substitués en totalité ou en partie, des radicaux alkyle condensés substitués en totalité ou en partie, des radicaux alkyle cycliques substitués en totalité ou en partie,
des groupes alcoxy, des amines, des amides, des esters, des carbonates, des groupes aromatiques, des groupes aromatiques substitués en totalité ou en partie, des groupes aromatiques condensés, des groupes aromatiques condensés substitués en totalité ou en partie, des hétérocycles, des hétérocycles substitués en totalité ou en partie, des hétérocycles condensés, F et CN.

2. Composé selon la revendication précédente, dans lequel le ligand est un ligand carbène.

3. Composé selon la revendication précédente, dans lequel au moins un parmi $R_1$ et $R_2$, $R_2$ et $R_3$, $R_{15}$ et $R_6$, $R_6$ et $R_7$, $R_7$ et $R_8$, $R_8$ et $R_y$ ou $R_y$ et $R_3$ sont pontés l'un avec l'autre.

**4.** Composé selon la revendication 1, dans lequel l'unité tautomérisable comprend une unité structurale choisie parmi - C(H,R)- ou -N(H)-, et relie un groupe aromatique pauvre en électrons et un groupe aromatique riche en électrons.

**5.** Composé selon la revendication précédente, qui est polynucléaire et comprend au moins deux atomes métalliques centraux M.

**6.** Composé selon la revendication précédente, dans lequel les au moins deux atomes métalliques centraux M sont reliés l'un avec l'autre par une interaction métal-métal.

**7.** Composé selon l'une des revendications 5 ou 6, dans lequel les au moins deux atomes métalliques centraux M sont reliés par au moins un ligand de pontage additionnel.

**8.** Composant émettant un rayonnement, comprenant :

- un substrat,
- une première couche d'électrode sur le substrat,
- au moins une couche émettrice organique sur la première couche d'électrode et
- une seconde couche d'électrode sur la couche émettrice organique,

la couche émettrice organique comprenant un composé de complexe métallique phosphorescent, le composé de complexe métallique phosphorescent comprenant au moins un atome métallique central M et au moins un ligand bidenté coordonné par l'atome métallique central M,

- l'un atome métallique central M et le ligand bidenté formant un cycle métallacyclique à six éléments,
- le ligand bidenté qui forme un cycle métallacyclique à six éléments avec l'atome métallique central comprenant à l'état non coordonné une unité tautomérisable, et
- l'atome métallique central M étant choisi dans un groupe qui comprend Ir, Pt, Au, Re, Rh, Ru, Os, Pd, Ag, Zn, Al et les lanthanides,

le composé présentant la formule structurale

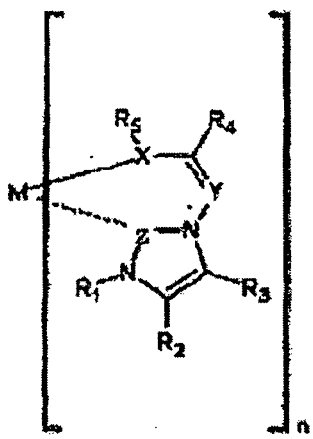

dans laquelle :

n = 1 à 3,
Y = C-H, N, P, As, Sb, C-$R_y$, Si-$R_y$, Ge-$R_y$,
X = N, O, P, As, Sb,
Z = C, Si, Ge,
$R_1$, $R_2$, $R_3$, $R_y$, $R_4$ et $R_5$ représentent, indépendamment les uns des autres, H, des radicaux alkyle non ramifiés, des radicaux alkyle ramifiés, des radicaux alkyle condensés, des radicaux alkyle cycliques, des radicaux alkyle non ramifiés substitués en totalité ou en partie, des radicaux alkyle ramifiés substitués en totalité ou en partie, des radicaux alkyle condensés substitués en totalité ou en partie, des radicaux alkyle cycliques substitués en totalité ou en partie, des groupes alcoxy, des amines, des amides, des esters, des carbonates, des groupes aromatiques, des groupes aromatiques substitués en totalité ou en partie, des groupes aromatiques condensés, des groupes aromatiques condensés substitués en totalité ou en partie, des hétérocycles, des hétérocycles substitués en totalité ou en partie, des hétérocycles condensés, F et CN.

**9.** Procédé de fabrication d'un composé de complexe métallique phosphorescent selon les revendications 1 à 7, comprenant les étapes de procédé suivantes :

A) la préparation d'un composé d'atome central d'un atome métallique central, qui comprend un ligand d'échange coordonné à l'atome central,
B) le mélange du composé d'atome central et d'un ligand dissous dans un premier solvant en un rapport stoechiométrique pour former le composé de complexe métallique,

le ligand d'échange étant remplacé par le ligand et le ligand comprenant une unité tautomérisable et formant avec l'atome central un cycle métallacyclique à six éléments par clivage d'un proton.

FIG 1

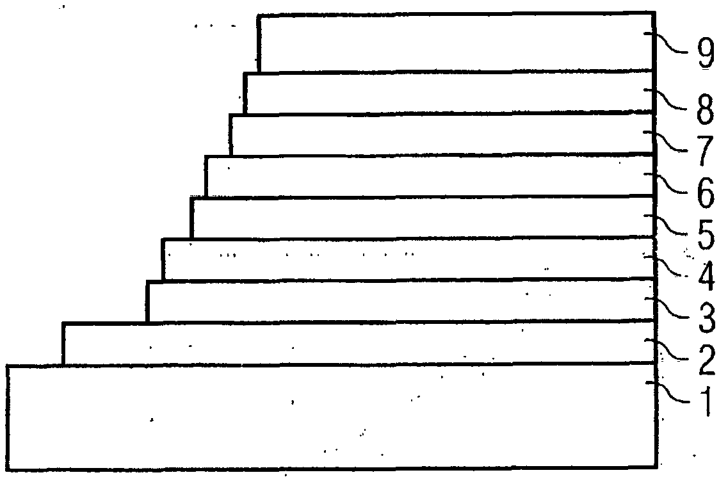

FIG 2

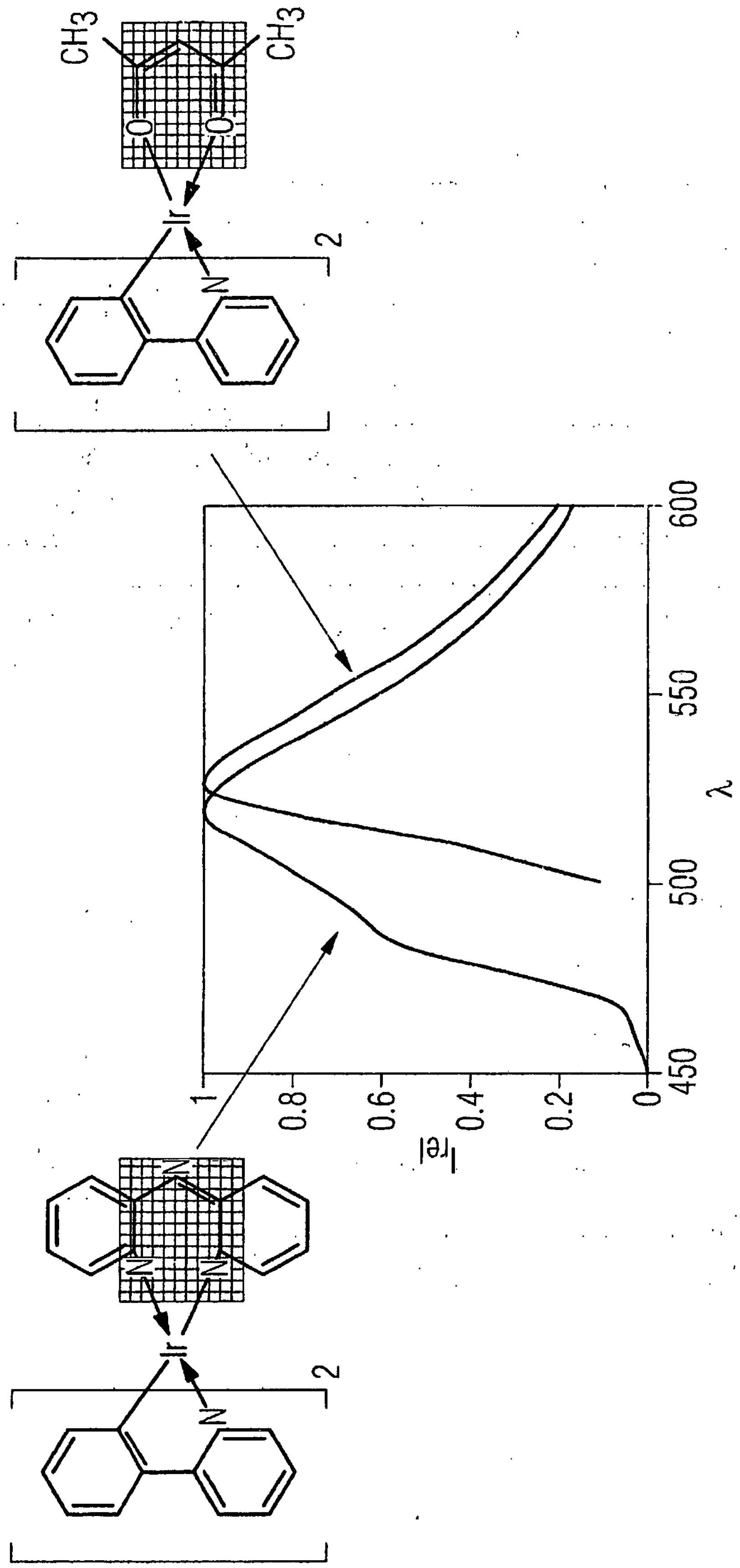

FIG 3a

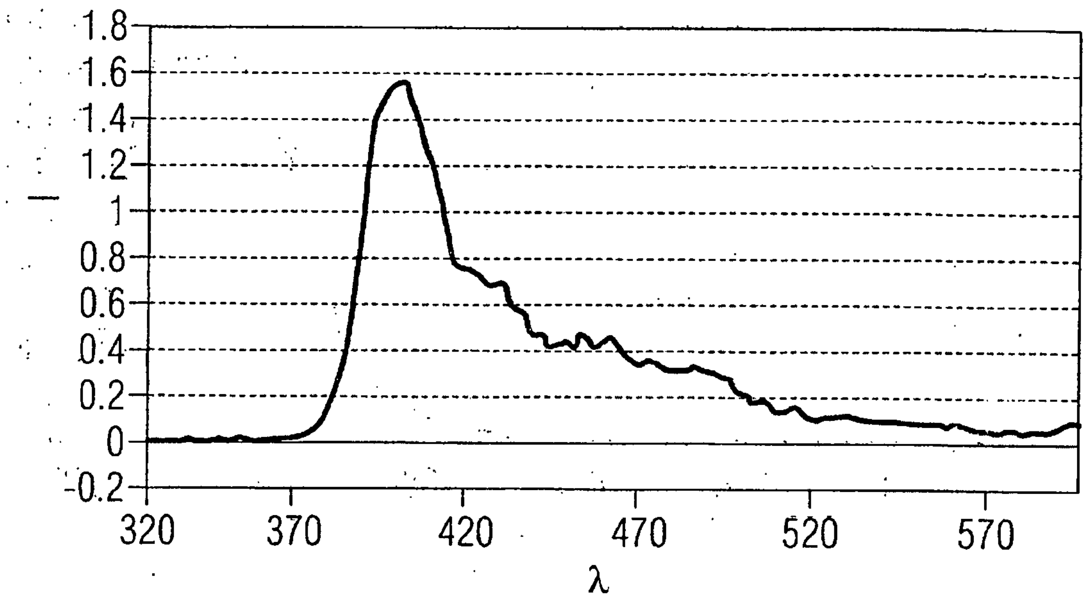
1.8
1.6
1.4
1.2
1
0.8
0.6
0.4
0.2
0
-0.2
320
370
420
470
520
570
λ

FIG 3b

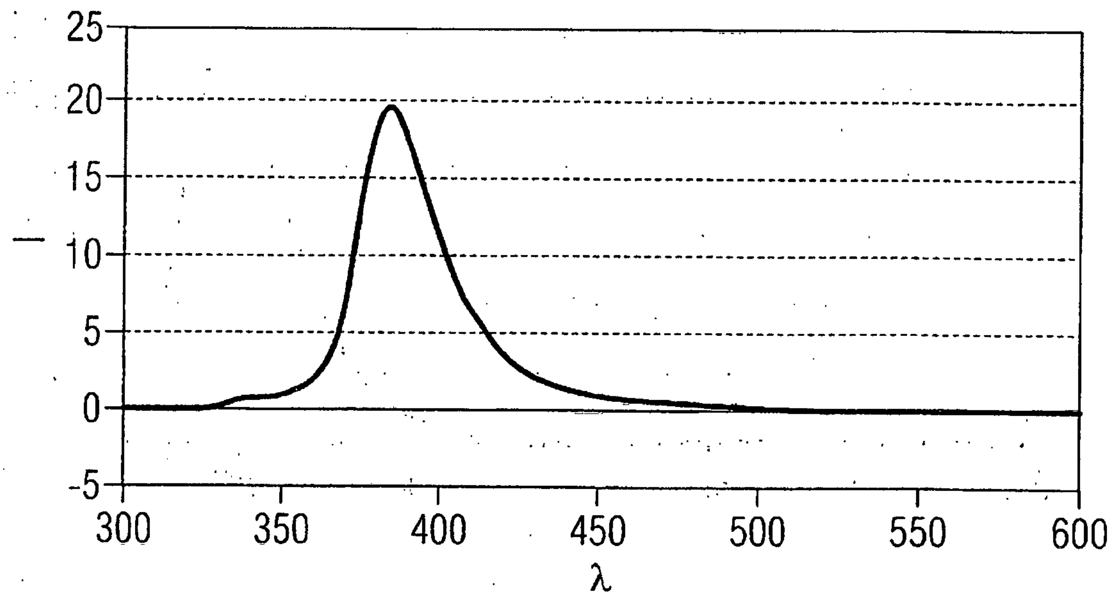
25
20
15
10
5
0
-5
300
350
400
450
500
550
600
λ

FIG 3c

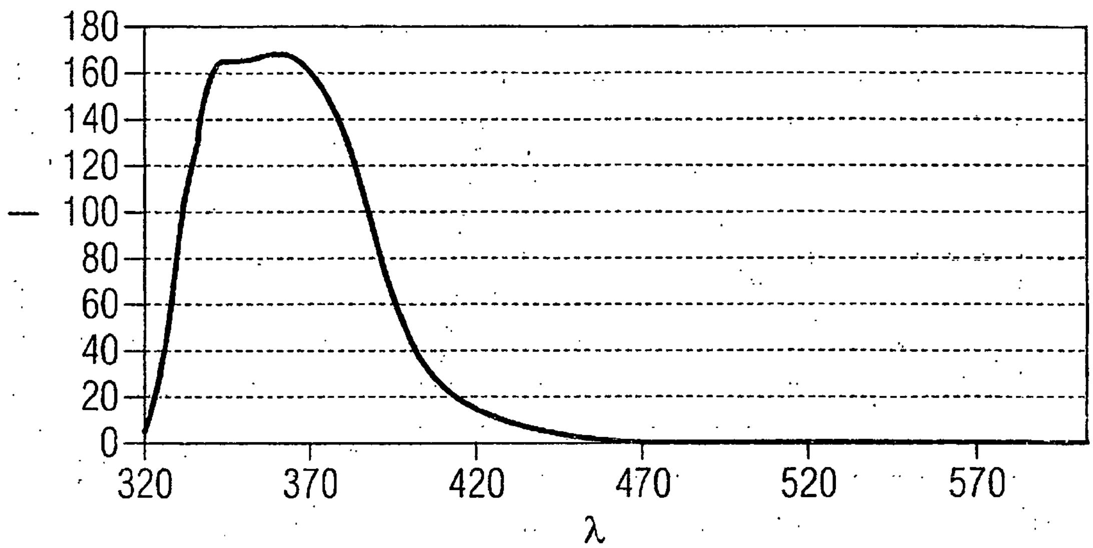
180
160
140
120
100
80
60
40
20
0
320
370
420
470
520
570
λ

FIG 3d

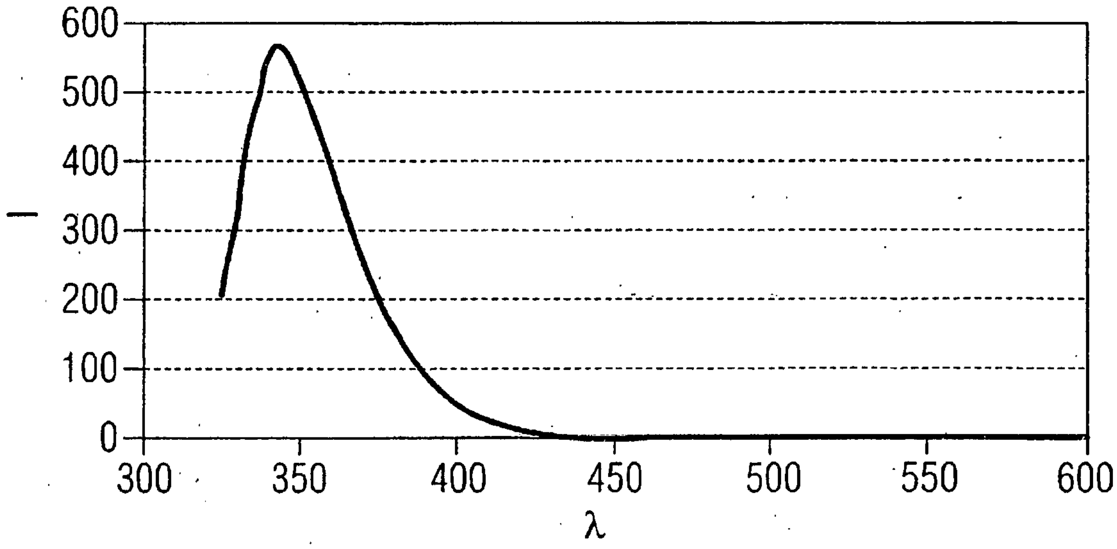
600
500
400
300
200
100
0
300
350
400
450
500
550
600
λ

FIG 3e

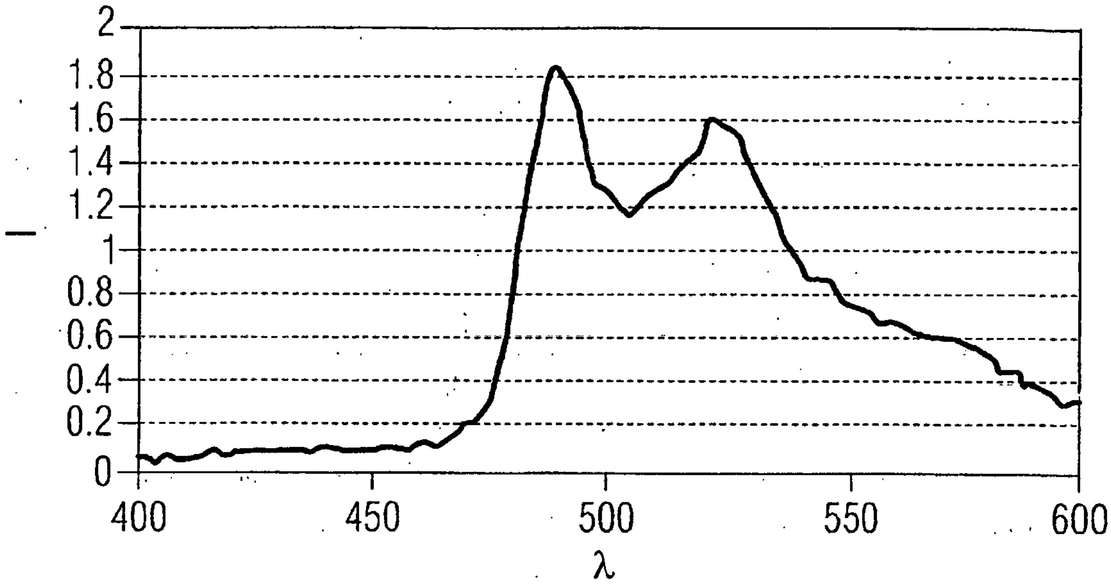
2
1.8
1.6
1.4
1.2
1
0.8
0.6
0.4
0.2
0
—
400
450
500
550
600
λ

FIG 3f

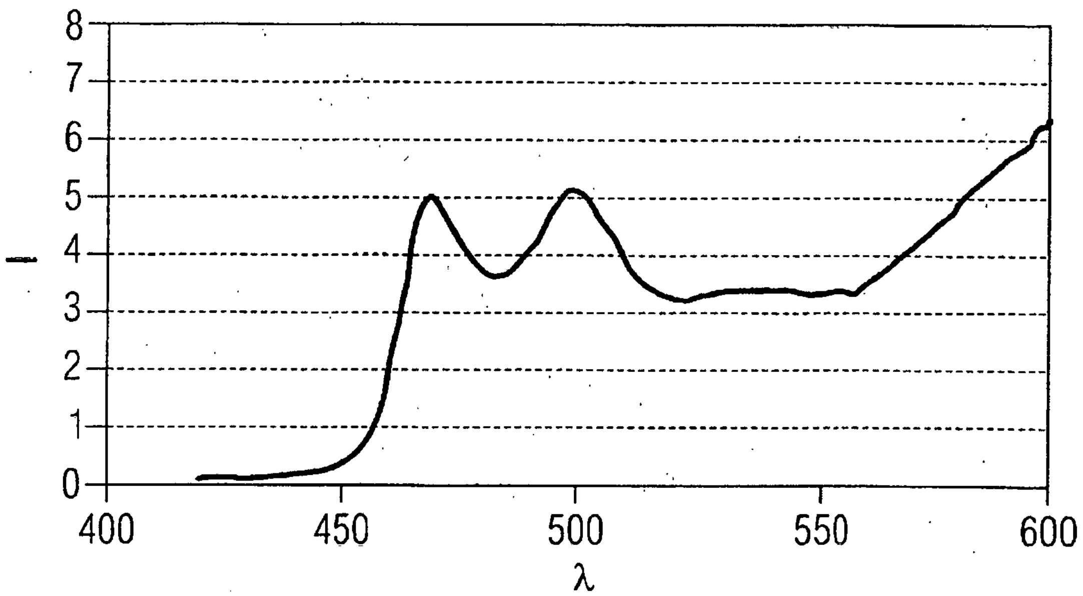
8
7
6
5
4
3
2
1
0
—
400
450
500
550
600
λ

FIG 3g

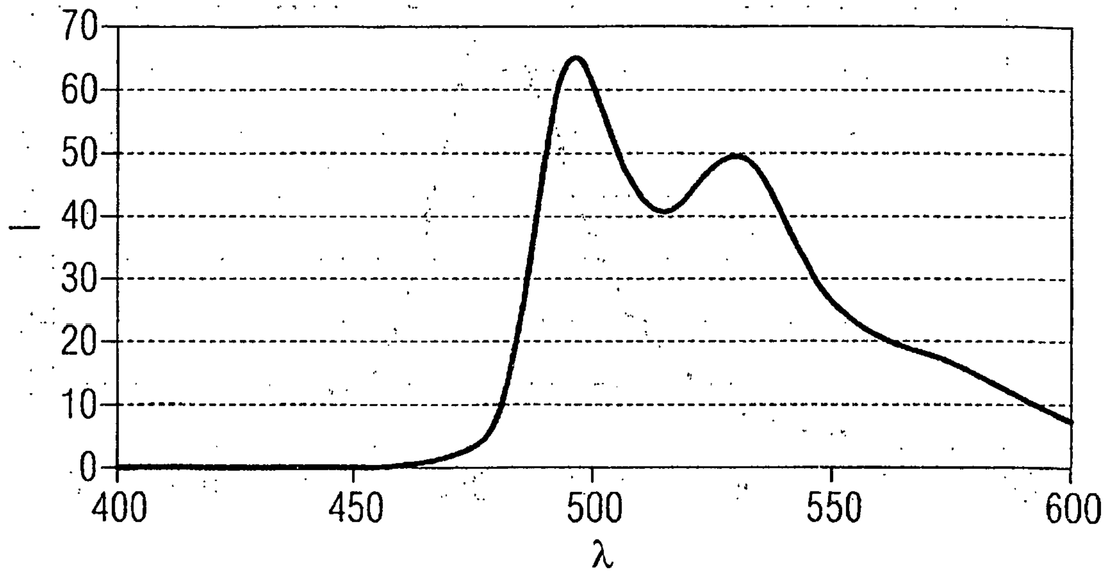
70
60
50
40
30
20
10
0
400
450
500
550
600
λ

FIG 3h

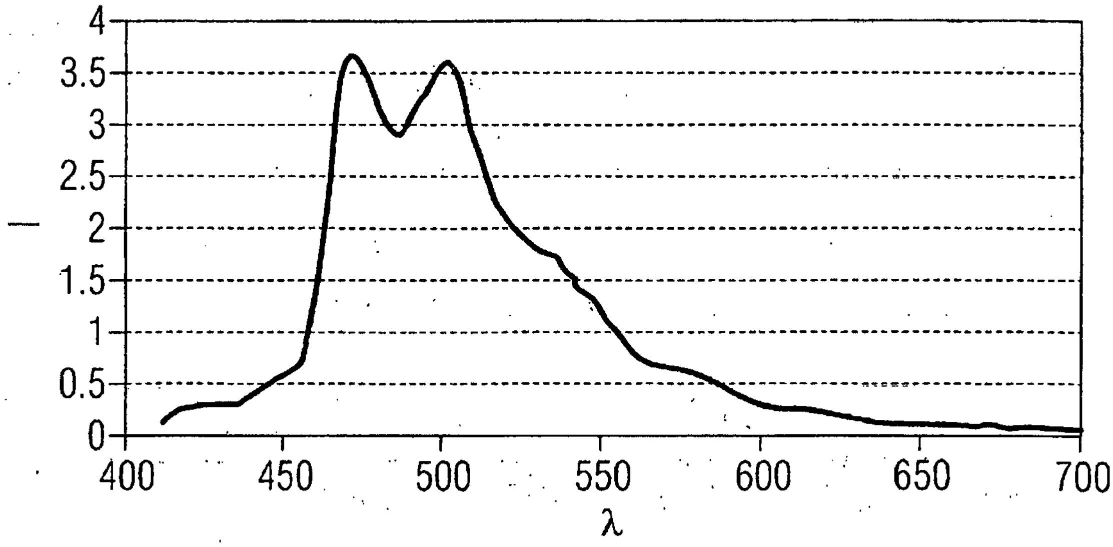
4
3.5
3
2.5
2
1.5
1
0.5
0
400
450
500
550
600
650
700
λ

FIG 3i

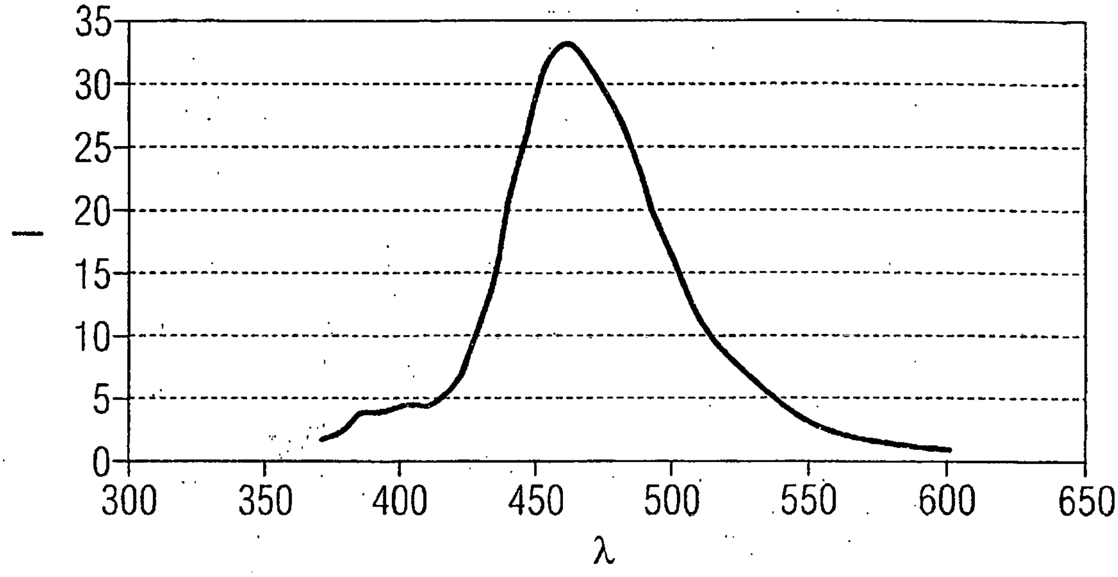
35
30
25
20
15
10
5
0
300
350
400
450
500
550
600
650
λ

FIG 3j

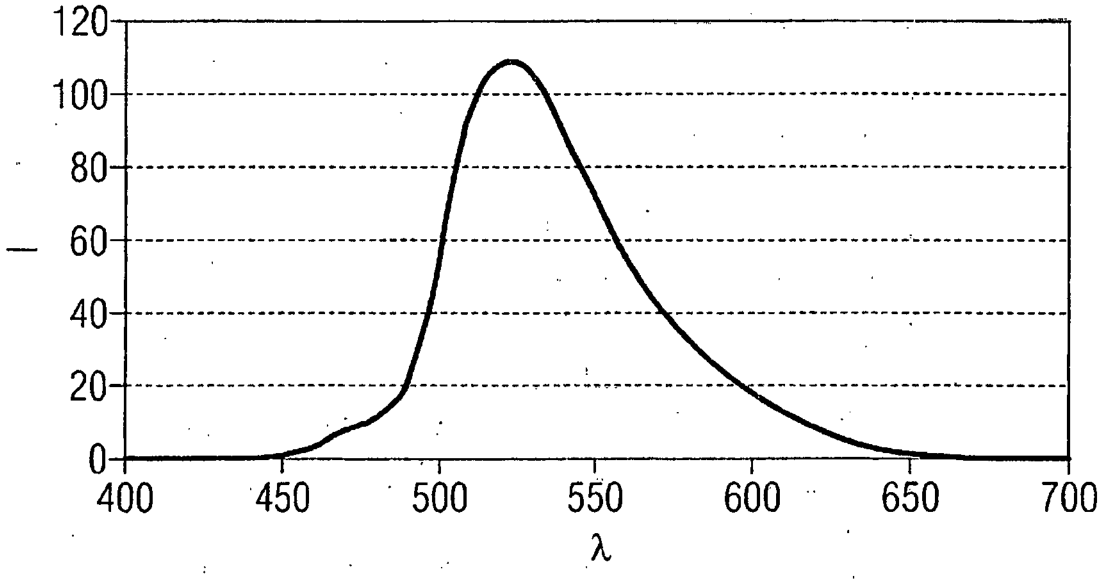
120
100
80
60
40
20
0
400
450
500
550
600
650
700
λ

FIG 4a

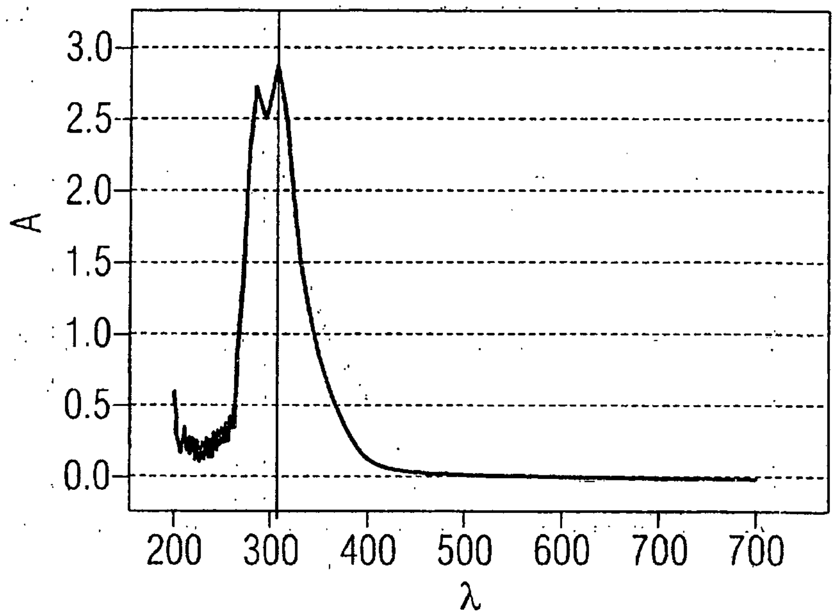
A
3.0
2.5
2.0
1.5
1.0
0.5
0.0
200
300
400
500
600
700
700
λ

FIG 4b

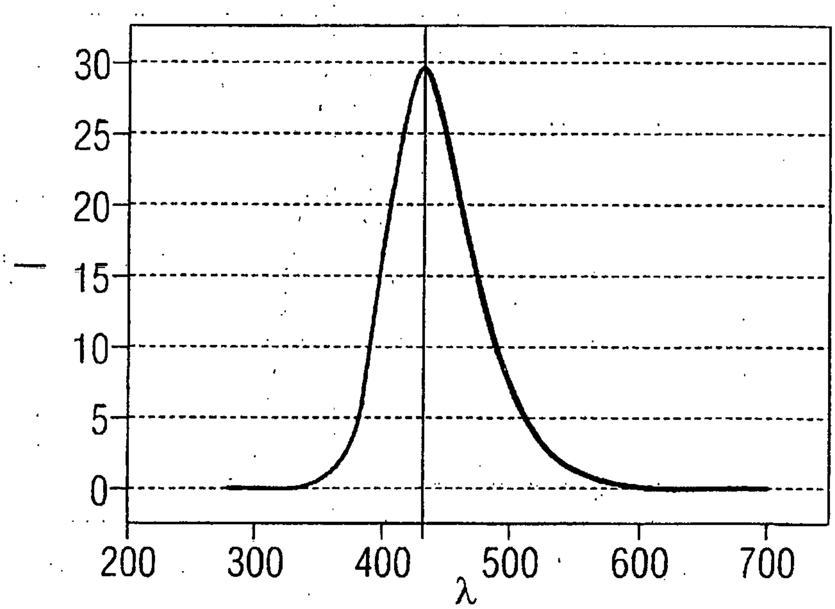
I
30
25
20
15
10
5
0
200
300
400
500
600
700
λ

FIG 5a

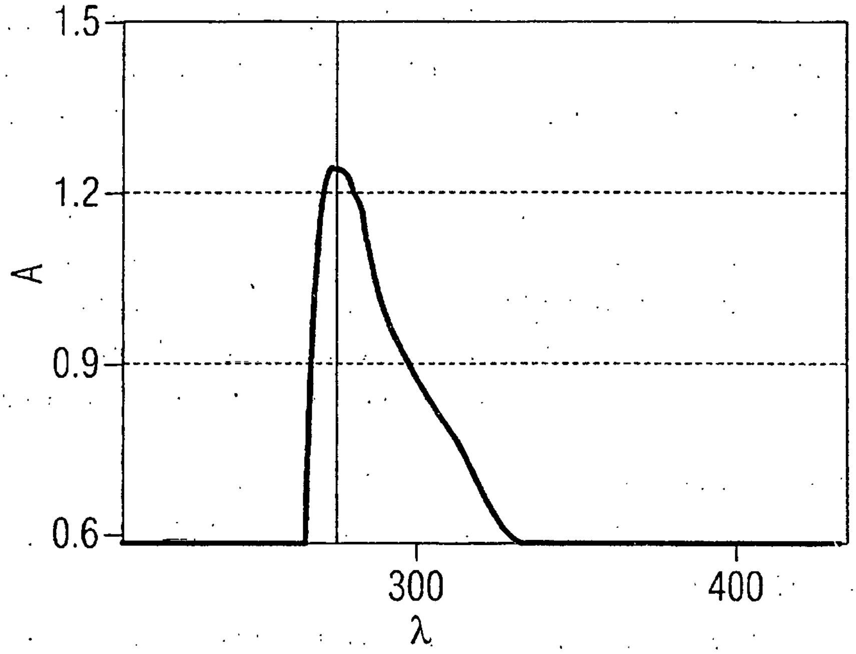


FIG 5b

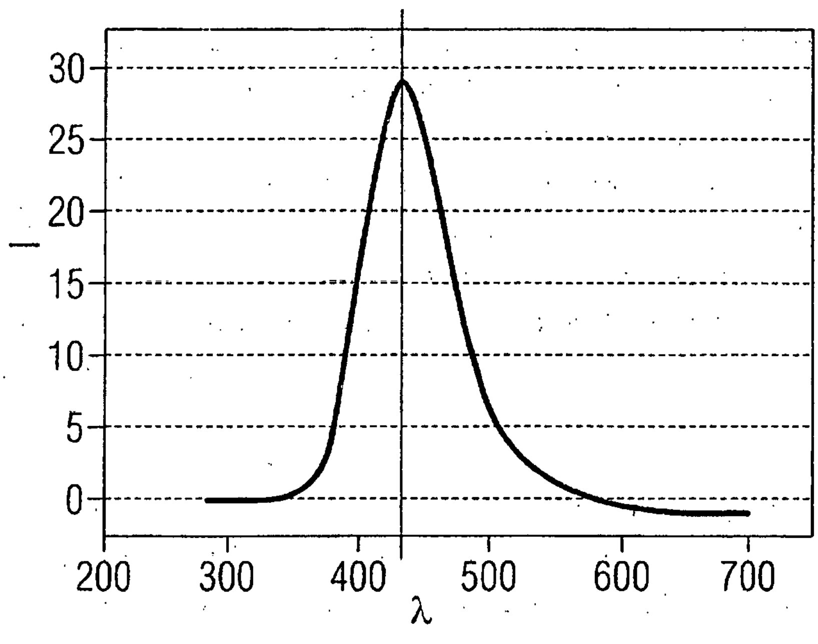

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 102008015940
- DE 102008004471
- DE 102008006113
- DE 102008006573
- DE 102007023554
- DE 102007023749
- JP 2007084635 A


### In der Beschreibung aufgeführte Nicht-Patentliteratur


- Multiple Bonds between Atoms. **COTTON ; MURILLO ; WALTON.** Inorg.Chem. Springerverlag, 2002, vol. 41, 3055
- *Dalton Trans.,* 2006, 4623-4631